(19) Europäisches Patentamt
European Patent Office
Office européen des brevets

(11) EP 2 808 173 A1

(12) **EUROPEAN PATENT APPLICATION**
published in accordance with Art. 153(4) EPC

(43) Date of publication:
**03.12.2014 Bulletin 2014/49**

(21) Application number: **13741159.1**

(22) Date of filing: **16.01.2013**

(51) Int Cl.:
***B41N 3/03*** (2006.01)

(86) International application number:
**PCT/JP2013/050673**

(87) International publication number:
**WO 2013/111652 (01.08.2013 Gazette 2013/31)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.01.2012 JP 2012012239**

(71) Applicant: **Fujifilm Corporation**
**Minato-ku**
**Tokyo 106-0031 (JP)**

(72) Inventors:
- **NAMBA Yusuke**
  **Haibara-gun**
  **Shizuoka 421-0396 (JP)**
- **OKANO Keio**
  **Haibara-gun**
  **Shizuoka 421-0396 (JP)**
- **KUROKAWA Shinya**
  **Haibara-gun**
  **Shizuoka 421-0396 (JP)**
- **SAWADA Hirokazu**
  **Haibara-gun**
  **Shizuoka 421-0396 (JP)**

(74) Representative: **Hoffmann Eitle**
**Patent- und Rechtsanwälte PartmbB**
**Arabellastraße 30**
**81925 München (DE)**

(54) **LITHOGRAPHIC PRINTING PLATE SUPPORT, LITHOGRAPHIC PRINTING PLATE SUPPORT MANUFACTURING METHOD AND LITHOGRAPHIC PRINTING PLATE MASTER**

(57) The purpose of the invention is to provide a lithographic printing plate support of excellent scratch resistance with which a lithographic printing plate master, which has excellent printing durability when made into a lithographic printing plate and exhibits excellent on-board developability and does not generate dot-shaped contamination even when stored over long periods, can be obtained. This lighographic printing plate support is provided with an aluminum plate and an aluminum anodized film thereon. The anodized film has micropores that extend in the depth direction from the surface opposite the aluminum plate. Said micropores are configured from a large diameter pore section, which has a specific shape, and a small diameter pore section, which communicates with the bottom of the large diameter pore section and has a specific shape. At least a portion of the inside of the small diameter pore section is sealed by protrusions obtained from boehmite. The ratio of the mean height of boehmite protrusions on the inside of the large diameter pore section to the mean diameter of the anodized film surface of the large diameter pore section is a specific value or less.

FIG.1

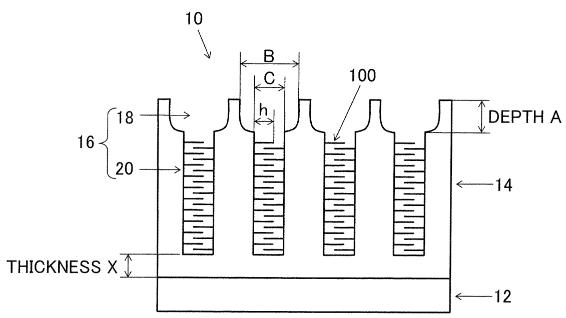


EP 2 808 173 A1

## Description

TECHNICAL FIELD

The present invention relates to a lithographic printing plate support, a method of manufacturing a lithographic printing plate support and a lithographic printing plate precursor.

[BACKGROUND ART]

The lithographic printing is a printing method that uses a lithographic printing plate having lipophilic regions (hereinafter also called "image areas") being ink receptive areas and hydrophilic regions (hereinafter also called "non-image areas") being ink non-receptive areas and that applies ink only on the image areas and transfers the ink to a printing medium such as paper.

Generally, a lithographic printing plate is manufactured by exposing to light, through a lith film or the like having an original image, a lithographic printing plate precursor in which a lipophilic image recording layer is formed on an aluminum support for a lithographic printing plate (hereinafter also called "lithographic printing plate support") and then resolving an unnecessary portion of the image recording layer to remove it so that a portion to be image areas of the image recording layer remains.

The lithographic printing plate is required to have image stability (long press life) in repetitive printing. The press life generally depends on adhesion between a lithographic printing plate support and an image recording layer, and other factors.

Furthermore, the lithographic printing plate support is required to have scratch resistance from the viewpoint that this property enables to suppress the transfer of scratches to the image recording layer when the lithographic printing plate precursor prepared therefrom is wound up or superposed on another, thus reducing scumming in non-image areas.

Meanwhile, many steps are needed in manufacturing the lithographic printing plate as mentioned above, and one method for rationalizing the steps is a method called "on-press development". The on-press development is a method in which an exposed lithographic printing plate precursor is mounted on a plate cylinder of a printing press and fountain solution and ink are supplied as the plate cylinder is rotated to thereby remove non-image areas of the lithographic printing plate precursor. Since the development is performed in the printing process, a development step is essentially omitted and the rationalization can be attained.

In order to apply the on-press development, it is necessary to completely remove non-image areas of the image recording layer with fountain solution or an ink solvent (on-press developability).

In the following description, the number of sheets of printing paper required to reach the state in which no ink is transferred to non-image areas after the completion of the on-press development of the unexposed areas is used to evaluate the on-press developability, which is rated "good" when the number of wasted sheets is small.

Under those circumstances, various studies have been made to satisfy the foregoing requirements. For example, Patent Literature 1 discloses a lithographic printing plate support produced by the method which includes a first step for anodizing an aluminum plate surface and a second step for reanodizing under such conditions that the pore size of micropores may be smaller than that of micropores in the anodized film formed in the first step, as well as a lithographic printing plate precursor obtained by using the thus produced lithographic printing plate support.

CITATION LIST

PATENT LITERATURE

Patent Literature 1: WO 2011/081064

SUMMARY OF INVENTION

TECHNICAL PROBLEMS

The present inventors studied the lithographic printing plate support as well as the lithographic printing plate precursor and a lithographic printing plate obtained by using the support described in Patent Literature 1, and as a result found that while scratch resistance, on-press developability and the press life certainly reach the currently required levels, ink is prone to adhere to part of a non-image area surface when the obtained lithographic printing plate precursor is stored for a long period of time, causing dot- or ring-shaped stains (hereinafter also referred to as "dotted scumming") on printed paper or the like.

Specifically, it is impossible with the conventional lithographic printing plate support to all attain, with a good

balance, the press life when the lithographic printing plate is formed therefrom, the on-press developability and resistance to dotted scumming when the lithographic printing plate precursor is formed therefrom, and the scratch resistance.

Then the present inventors have studied what causes dotted scumming and as a result found that the main cause thereof is the penetration of moisture or ions (particularly halide ion) contained in an image recording layer formed on the anodized film into the anodized film and further into the aluminum plate under the anodized film. Upon penetrating through aluminum ions, moisture or ions react with intermetallic compounds (particularly Al-Fe intermetallic compounds) present in the aluminum plate so that the lithographic printing plate support is corroded, thus causing dotted scumming.

In view of the situation as described above, an object of the invention is to provide a lithographic printing plate support excellent in scratch resistance that allows a lithographic printing plate to have a long press life and a lithographic printing plate precursor to have a high on-press developability and causing no dotted scumming even after a long-term storage, and a manufacturing method thereof.

SOLUTION TO PROBLEMS

The present inventors have made an intensive study to achieve the above object and as a result found that the foregoing problem can be solved by obtaining a lithographic printing plate support in which micropores in an anodized film are each formed of a large-diameter portion and a small-diameter portion respectively having specific shapes; at least a part of the inside of the small-diameter portions is sealed with protrusions made of boehmite; and the ratio of an average height of the protrusions made of boehmite inside the large-diameter portions to an average diameter of the large-diameter portions at the surface of the anodized film is equal to or less than a predetermined value.

Specifically, the invention provides the following (1) to (11).

(1) A lithographic printing plate support, comprising an aluminum plate and an anodized film of aluminum formed on the aluminum plate and having micropores extending in the anodized film from a surface of the anodized film opposite from the aluminum plate in a depth direction,
wherein each of the micropores has a large-diameter portion which extends from the surface of the anodized film to a depth (depth A) of 5 to 60 nm and a small-diameter portion which communicates with a bottom of the large-diameter portion and extends to a depth of 890 to 2,000 nm from a level of communication between the small-diameter portion and the large-diameter portion,
wherein the large-diameter portion has an average diameter B of 10 to 60 nm at the surface of the anodized film,
wherein a ratio (C/B) of an average diameter C of the small-diameter portion at the level of communication to the average diameter B of the large-diameter portion at the surface of the anodized film is up to 0.85,
wherein at least a part of an inside of the small-diameter portion is sealed with protrusions made of boehmite, and
wherein a ratio (k/B) of an average height k of protrusions made of boehmite inside the large-diameter portion to the average diameter B of the large-diameter portion is up to 0.27.

(2) The lithographic printing plate support according to (1), wherein a ratio (h/C) of an average height h of the protrusions inside the small-diameter portion to the average diameter C of the small-diameter portion is from 0.5 to 1.0.

(3) The lithographic printing plate support according to (1) or (2), wherein a sealing ratio of the small-diameter portion is at least 30%

(4) The lithographic printing plate support according to any one of (1) to (3), wherein the average diameter C of the small-diameter portion is up to 15 nm.

(5) The lithographic printing plate support according to any one of (1) to (4), wherein a thickness of the anodized film from a bottom of the small-diameter portion to a surface of the aluminum plate is at least 30 nm.

(6) The lithographic printing plate support according to any one of (1) to (5), wherein a content of intermetallic compounds in the alumunum plate is up to 0.060 wt%.

(7) The lithographic printing plate support according to any one of (1) to (6), wherein the average diameter B of the large-diameter portion is from 10 to 50 nm.

(8) The lithographic printing plate support according to any one of (1) to (7), wherein the depth A of the large-diameter portion is from 10 to 55 nm.

(9) A lithographic printing plate support manufacturing method of manufacturing the lithographic printing plate support according to any one of (1) to (8), comprising:

- a first anodizing treatment step for anodizing the aluminum plate;
- a pore-widening treatment step for enlarging a diameter of the micropores in the anodized film by bringing the aluminum plate having the anodized film obtained in the first anodizing treatment step into contact with an aqueous acid or alkali solution;
- a second anodizing treatment step for anodizing the aluminum plate obtained in the pore-widening treatment

step; and

a water vapor treatment step for bringing the aluminum plate obtained in the second anodizing treatment step into contact with water vapor at a temperature of 150°C or higher but lower than 300°C.

(10) A lithographic printing plate support manufacturing method of manufacturing the lithographic printing plate support according to any one of (1) to (8), comprising:

a first anodizing treatment step for anodizing the aluminum plate;

a second anodizing treatment step for anodizing the aluminum plate obtained in the first anodizing treatment step; and

a water vapor treatment step for bringing the aluminum plate obtained in the second anodizing treatment step into contact with water vapor at 150°C or more but less than 300°C. (11) A lithographic printing plate precursor comprising: the lithographic printing plate support according to any one of (1) to (8); and an image recording layer formed on the lithographic printing plate support.

ADVANTAGEOUS EFFECTS OF INVENTION

The present invention provides a lithographic printing plate support that has excellent scratch resistance, that is capable of obtaining a lithographic printing plate precursor which exhibits excellent on-press developability and is free from dotted scumming even after a long-term storage and that enables a lithographic printing plate formed therefrom to have a long press life, and a manufacturing method thereof.

BRIEF DESCRIPTION OF THE DRAWINGS

[FIG. 1] FIG. 1 is a schematic cross-sectional view showing an embodiment of a lithographic printing plate support of the invention.

[FIG. 2] FIG. 2 is a schematic cross-sectional view showing another example of the embodiment of the lithographic printing plate support of the invention.

[FIG. 3] FIG. 3 is a schematic cross-sectional view showing another example of the embodiment of the lithographic printing plate support of the invention.

[FIG. 4] FIG. 4 is a schematic cross-sectional view showing another example of the embodiment of the lithographic printing plate support of the invention.

[FIG. 5] FIG. 5 includes schematic cross-sectional views each showing an aluminum plate and an anodized film, as arranged in the order of process steps for illustrating a lithographic printing plate support manufacturing method of the invention.

[FIG. 6] FIG. 6 is a graph showing an example of an alternating current waveform that may be used in electrochemical graining treatment in the lithographic printing plate support manufacturing method of the invention.

[FIG. 7] FIG. 7 is a side view showing an example of a radial cell in electrochemical graining treatment with alternating current in the method of manufacturing the lithographic printing plate support of the invention.

[FIG. 8] FIG. 8 is a side view conceptually showing a brush graining step used in mechanical graining treatment during manufacture of the lithographic printing plate support of the invention.

[FIG. 9] FIG. 9 is a schematic view of an anodizing apparatus that may be used in anodizing treatment during manufacture of the lithographic printing plate support of the invention.

DESCRIPTION OF EMBODIMENTS

Preferred embodiments of a lithographic printing plate support and its manufacturing method according to the invention are described below.

First, the features of the invention as compared to the conventional art are described.

A lithographic printing plate support of the invention is characterized in that it includes an aluminum plate and an anodized film formed thereon, whereupon micropores in the anodized film are each formed of a large-diameter portion having a predetermined aperture diameter and a small-diameter portion having a predetermined aperture diameter that communicate with each other along the depth direction, at least a part of the inside of each small-diameter portion is sealed with protrusions made of boehmite ($Al_2O_3 \cdot H_2O$ or $AlO(OH)$) (hereinafter also called "boehmite protrusions"), and the ratio of an average height of the protrusions made of boehmite in the large-diameter portions to an average diameter of the large-diameter portions at a surface of the anodized film is equal to or less than a predetermined value.

The lithographic printing plate support of the invention includes the large-diameter portions having the predetermined aperture diameter in the anodized film as described above, and therefore achieve a good balance between adhesion to image areas and dissolution and removal properties of non-image areas during the on-press development. Consequently, a lithographic printing plate obtained by using the support has a long press life while a lithographic printing plate precursor obtained by using the support exhibits excellent on-press developability. Since each large-diameter portion communicates along the depth direction with the corresponding small-diameter portion having the predetermined aperture diameter, the anodized film has a specific thickness and hence scratch resistance is ensured. Since at least a part of the inside of each small-diameter portion is sealed with the boehmite protrusions, even after the lithographic printing plate precursor obtained by using the support is stored for a long period of time, water or ions in an image recording layer hardly penetrate into the anodized film and hence the reaction with intermetallic compounds present in the aluminum plate is suppressed, so that the corrosion of the lithographic printing plate support is suppressed and excellent resistance to dotted scumming is exhibited. In addition, since the ratio of the average height of the boehmite protrusions inside the large-diameter portions to the aperture diameter of the large-diameter portions is equal to or less than the predetermined value, the lithographic printing plate precursor formed from the support exhibits excellent on-press developability without having excessive anchor effect at image areas.
FIG. 1 is a schematic cross-sectional view showing an embodiment of a lithographic printing plate support of the invention.
A lithographic printing plate support 10 shown in the drawing is of a laminated structure in which an aluminum plate 12 and an anodized aluminum film 14 are stacked in this order. The anodized film 14 has micropores 16 extending from its surface toward the aluminum plate 12 side, and each micropore 16 has a large-diameter portion 18 and a small-diameter portion 20. At least a part of the inside of each small-diameter portion 20 is sealed with boehmite protrusions 100. The ratio of an average height of the boehmite protrusions inside the large-diameter portions to an average diameter of the large-diameter portions at the surface of the anodized film is equal to or less than a predetermined value.
The aluminum plate 12 and the anodized film 14 are first described in detail.

<Aluminum Plate>

The aluminum plate 12 that may be used in the invention is made of a dimensionally stable metal composed primarily of aluminum; that is, aluminum or aluminum alloy. The aluminum plate is selected from among plates of pure aluminum, alloy plates composed primarily of aluminum and containing small amounts of other elements, and plastic films or paper on which aluminum (alloy) is laminated or vapor-deposited. In addition, a composite sheet as described in JP 48-18327 B in which an aluminum sheet is combined with a polyethylene terephthalate film may be used.
In the following description, the above-described plates made of aluminum or aluminum alloys are referred to collectively as "aluminum plate 12." Other elements which may be present in the aluminum alloy include silicon, iron, manganese, copper, magnesium, chromium, zinc, bismuth, nickel and titanium. The content of other elements in the alloy is not more than 10 wt%.
The amount of intermetallic compounds contained in the aluminum plate 12 is not particularly limited, and is preferably up to 0.500 wt%, more preferably up to 0.100 wt%, even more preferably up to 0.060 wt%, still even more preferably up to 0.050 wt%, and most preferably up to 0.030 wt% because more excellent resistance to dotted scumming is achieved.
The term "intermetallic compounds" as used herein refers to compounds (e.g., $FeAl_3$, $FeAl_6$, $\alpha$-AlFeSi, $TiAl_3$ and $CuAl_2$) produced in an aluminum alloy by eutectic crystallization of the alloying ingredients in aluminum which are not present in solid solution in aluminum (The Fundamentals of Aluminum Materials and Industrial Technology, Japan Light Metal Association, page 32). An intermetallic compound is usually composed of two or more metallic elements and it is known that the constituent atom ratio is not necessarily equivalent to a stoichiometric ratio.
Exemplary intermetallic compounds containing two or more metallic elements include those containing two elements such as $Al_3Fe$, $Al_6Fe$, $Mg_2Si$, $MnAl_6$, $TiAl_3$ and $CuAl_2$; those containing three elements such as $\alpha$-AlFeSi and $\beta$-AlFeSi; and those containing four elements such as $\alpha$-AlFeMnSi and $\beta$-AlFeMnSi.

<Anodized Film>

The anodized film 14 refers to an anodized aluminum film that is formed at a surface of the aluminum plate 12 by anodizing treatment and has the micropores 16 which are substantially perpendicular to the film surface and are distributed uniformly with one another.
The micropores 16 extend from the surface of the anodized film opposite from the aluminum plate 12 along the thickness direction of the anodized film toward the aluminum plate 12 side.
Each micropore 16 in the anodized film 14 has the large-diameter portion 18 which extends to a depth of 5 to 60 nm from the anodized film surface (depth A: see FIG. 1), and the small-diameter portion 20 which communicates

with the bottom of the large-diameter portion 18 and further extends to a depth of 890 to 2,000 nm from the level of communication.

The large-diameter portion 18 and the small-diameter portion 20 are described below in detail.

(Large-Diameter Portion)

The large-diameter portions 18 have an average diameter B (average aperture diameter) (hereinafter also called "average diameter B of the large-diameter portion 18" or simply "average diameter B") of 10 to 60 nm at the surface of the anodized film. When the average diameter B is within the above-defined range, this leads to the lithographic printing plate support that allows the lithographic printing plate formed therefrom to have a long press life and the lithographic printing plate precursor formed therefrom to have a high on-press developability.

The average diameter B is preferably from 10 to 50 nm, more preferably from 15 to 50 nm and even more preferably from 20 to 50 nm because the lithographic printing plate precursor obtained by using the lithographic printing plate support of the invention is more excellent in resistance to dotted scumming and on-press developability.

At an average diameter B of less than 10 nm, the anchor effect is small and the resulting lithographic printing plate cannot have a sufficient press life. At an average diameter B in excess of 60 nm, the resulting lithographic printing plate precursor cannot have sufficient on-press developability.

The average diameter B is determined as follows: The surface of the anodized film 14 is observed with FE-SEM at a magnification of 150,000X to obtain four images (N = 4), in the resulting four images, the diameter of the micropores (large-diameter portions) within an area of 400 x 600 $nm^2$ is measured, and the arithmetic mean of the measurements is calculated.

The equivalent circle diameter is used if the aperture of the large-diameter portion 18 at the anodized film surface is not circular. The "equivalent circle diameter" refers to a diameter of a circle assuming that the shape of the aperture is the circle having the same projected area as that of the aperture.

The bottom of each large-diameter portion 18 is at a depth of 5 to 60 nm from the surface of the anodized film (depth A). In other words, each large-diameter portion 18 is a pore portion which extends from the surface of the anodized film in the depth direction (thickness direction) to a depth of 5 to 60 nm. When the depth A is within the above-defined range, this leads to the lithographic printing plate support that allows the lithographic printing plate precursor formed therefrom to have a high on-press developability. The depth A is preferably from 10 nm to 55 nm because the lithographic printing plate obtained by using the lithographic printing plate support of the invention has more excellent on-press developability.

At a depth A of less than 5 nm, the anchor effect is small and the resulting lithographic printing plate cannot have a sufficient press life. At a depth A in excess of 60 nm, the resulting lithographic printing plate precursor cannot have sufficient on-press developability.

The depth A is determined as follows: The cross-section of the anodized film 14 is observed with FE-TEM at a magnification of 500,000X, the depth (the distance from the anodized film surface to the level of communication) of at least 25 (e.g., 60 (N = 60)) large-diameter portions is measured, and the arithmetic mean of the measurements is calculated. For observation of the cross-section of the anodized film, a known method may be adopted (for instance, the anodized film is cut by FIB to prepare a thin film (about 50 nm) to thereby observe the cross-section of the anodized film).

The shape of the large-diameter portions 18 is not particularly limited. Exemplary shapes include a substantially straight tubular shape (substantially cylindrical shape) shown in FIG. 1, an inverted cone shape (tapered shape) in which the diameter decreases from the surface of the anodized film toward the aluminum plate 12 and a substantially conical shape (inversely tapered shape) in which the diameter increases from the surface of the anodized film toward the aluminum plate 12. A preferred shape is a substantially straight tubular shape.

The internal diameter of the large-diameter portions 18 is not particularly limited and is usually substantially equal to or smaller than the diameter of the apertures at the anodized film surface. There may be usually a difference of about 1 nm to about 10 nm between the internal diameter of the large-diameter portions 18 and the aperture diameter thereof.

In the case where boehmite protrusions (not shown in the drawing) are present inside the large-diameter portions 18, the ratio (k/B) of an average height k of the boehmite protrusions to the average diameter B of the large-diameter portions is up to 0.27. In the lithographic printing plate support of the invention, the ratio k/B is within the above-defined range and therefore the lithographic printing plate precursor formed therefrom has excellent on-press developability. In particular, the ratio k/B is preferably up to 0.20 and more preferably up to 0.12. It is still more preferable that the large-diameter portions 18 be essentially not sealed with the boehmite protrusions.

Specifically, it is needed that no boehmite protrusion be present inside the large-diameter portions 18 (k/B = 0) or that, if the boehmite protrusions are present, the ratio k/B be up to 0.27.

The "average height k" above refers to an average value of the height k of the boehmite protrusions extending from surfaces of the large-diameter portions 18 inside the large-diameter portions. The height k corresponds to the

maximum length from the top to the bottom of a protrusion.

A measurement method of the average height of the boehmite protrusions inside the large-diameter portions is the same as that for the boehmite protrusions inside the small-diameter portions to be described later.

(Small-Diameter Portion)

As shown in FIG. 1, each of the small-diameter portions 20 is a pore portion which communicates with the bottom of the corresponding large-diameter portion 18 and further extends from the level of communication in the depth direction (thickness direction). One small-diameter portion 20 usually communicates with one large-diameter portion 18 but two or more small-diameter portions 20 may communicate with the bottom of one large-diameter portion 18.

An average diameter C of the small-diameter portions 20 at the level of communication (hereinafter also called "average diameter C of the small-diameter portions 20" or simply "average diameter C") is smaller than the average diameter B of the large-diameter portions 18, and the ratio (C/B) of the average diameter C of the small-diameter portions 20 at the level of communication to the average diameter B of the large-diameter portions 18 is up to 0.85. When the ratio is within the above-defined range, this leads to the lithographic printing plate support that is capable of obtaining a lithographic printing plate precursor which exhibits excellent on-press developability.

The foregoing ratio (C/B) is preferably up to 0.70 and more preferably up to 0.40 because the lithographic printing plate precursor obtained by using the lithographic printing plate support of the invention has more excellent resistance to dotted scumming. The lower limit thereof is not particularly limited, and is preferably at least 0.02 and more preferably at least 0.10 in terms of ease of manufacture.

The average diameter C is preferably less than 20 nm, more preferably 15 nm or less and even more preferably from 5 to 10 nm because the lithographic printing plate precursor obtained by using the lithographic printing plate support of the invention has more excellent resistance to dotted scumming.

In the case where only the large-diameter portions are present and no small-diameter portion is present, a lithographic printing plate support obtained is to have insufficient scratch resistance.

The average diameter C is determined as follows: The cross-section of the anodized film 14 is observed with FE-TEM at a magnification of 500,000X, the diameter of 60 (N = 60) micropores (small-diameter portions) (the diameter at the level of communication with the corresponding large-diameter portions 18) is measured, and the arithmetic mean of the measurements is calculated. For observation of the cross-section of the anodized film, a known method may be adopted (for instance, the anodized film is cut by FIB to prepare a thin film (about 50 nm) to thereby observe the cross-section of the anodized film).

The equivalent circle diameter is used if the small-diameter portion 20 does not have a circular aperture at the level of communication. The "equivalent circle diameter" refers to a diameter of a circle assuming that the shape of an aperture at the level of communication is the circle having the same projected area as that of the aperture.

The bottom of each small-diameter portion 20 is at a distance of 890 to 2,000 nm in the depth direction from the level of communication with the corresponding large-diameter portion 18 (which level corresponding to the above-described depth A). In other words, each small-diameter portion 20 is a pore portion which further extends to a depth of 890 to 2,000 nm in the depth direction (thickness direction) from the level of communication with the corresponding large-diameter portion 18. The bottom is preferably at a distance of 900 to 1500 nm from the level of communication because the lithographic printing plate precursor obtained by using the lithographic printing plate support of the invention has more excellent on-press developability.

At a depth of less than 890 nm, the resulting lithographic printing plate precursor has poor on-press developability or poor scratch resistance. A depth in excess of 2,000 nm requires a prolonged treatment time and reduces the productivity and economic efficiency.

The depth is determined by taking a cross-sectional image of the anodized film 14 (at a magnification of 50,000X), measuring the depth of at least 25 small-diameter portions, and calculating the arithmetic mean of the measurements.

In the lithographic printing plate support of the invention, at least a part of the inside of each small-diameter portion 20 is sealed with the boehmite protrusions 100 as shown in FIG. 1. To be more specific, upon hydration reaction between aluminum oxide and water, the boehmite protrusions 100 are produced inside the small-diameter portions 20 at side surfaces thereof and grow in a direction substantially perpendicular to the side surfaces. In FIG. 1, the maximum length from the top to the bottom of each boehmite protrusion 100 is denoted by the height h.

Moisture or ions hardly penetrate the anodized film 14 under the condition where the small-diameter portions 20 are sealed with the boehmite protrusions 100.

Specifically, even when a lithographic printing plate precursor prepared by forming an image recording layer on the anodized film 14 is stored for a long period of time, moisture or ions contained in the image recording layer does not reach the aluminum plate 12, so that the aluminum plate 12 is not corroded and the occurrence of dotted scumming is suppressed.

The ratio (h/C) of an average height h of the boehmite protrusions 100 to the average diameter C of the small-diameter portions 20 is preferably from 0.2 to 1.0, more preferably from 0.5 to 1.0, even more preferably from 0.7 to 1.0 and most preferably from 0.9 to 1.0 because the lithographic printing plate precursor obtained by using the lithographic printing plate support of the invention has more excellent resistance to dotted scumming.
The "average height h" above refers to an average value of the maximum length (height h) from the top to the bottom of the boehmite protrusion 100 sealing the small-diameter portions 20.
The average height h of the boehmite protrusions 100 may be determined as follows: The lithographic printing plate support is cut by FIB to prepare an ultrathin section, the obtained ultrathin section is observed with FE-TEM (at a magnification of 800,000X), the height h of the boehmite protrusions inside at least 25 small-diameter portions is measured, and the arithmetic mean of the measurements is calculated.
A sealing ratio of the small-diameter portions 20 by the boehmite protrusions therein is preferably at least 3%, more preferably at least 30%, even more preferably at least 50% and still even more preferably at least 75% because the lithographic printing plate precursor obtained by using the lithographic printing plate support of the invention has more excellent resistance to dotted scumming.
The sealing ratio of the small-diameter portions herein refers to a reduction ratio of a specific surface area of the small-diameter portions when the small-diameter portions are sealed with the boehmite protrusions.
More specifically, the sealing ratio may be determined as follows:

First, a support having micropores each composed of a large-diameter portion and a small-diameter portion is subjected to sealing treatment, and a specific surface area p1 before sealing and a specific surface area p2 after sealing are measured.

Next, a support having micropores composed only of large-diameter portions is prepared and subjected to sealing treatment under the same conditions as above, and a specific surface area q1 of the support before sealing and a specific surface area q2 of the same after sealing are measured.

A specific surface area of the small-diameter portions before sealing is expressed by p1 - q1. A specific surface area of the small-diameter portions after sealing is expressed by p2 - q2.
The sealing ratio is determined from the obtained specific surface areas in accordance with the following equation.

$$(\text{Sealing ratio } (\%)) = [\{(p1 - q1) - (p2 - q2)\} / (p1 - q1)] \times 100$$

The specific surface areas are determined by BET method with the use of nitrogen adsorption as measured.
The shape of the small-diameter portions 20 is not particularly limited. Exemplary shapes include a substantially straight tubular shape (substantially cylindrical shape), a conical shape in which the diameter decreases in the depth direction, and a dendritic shape in which a small-diameter portion extends in the depth direction (thickness direction) while branching off, and a substantially straight tubular shape is preferred. The bottom shape of the small-diameter portions 20 is not particularly limited and may be curved (convex) or flat.
The internal diameter of the small-diameter portions 20 is not particularly limited and may be usually substantially equal to, or smaller or larger than the diameter at the level of communication. There may be usually a difference of about 1 nm to about 10 nm between the internal diameter of the small-diameter portions 20 and the diameter at the level of communication.

(Barrier Layer)

The thickness of the anodized film (corresponding to thickness X in FIG. 1) from the bottom of the small-diameter portions 20 to the surface of the aluminum plate 12 is not particularly limited, and is preferably at least 5 nm and more preferably at least 30 nm, but preferably up to 100 nm and more preferably up to 80 nm because the lithographic printing plate precursor obtained by using the lithographic printing plate support of the invention has more excellent resistance to dotted scumming. The portion corresponding to the thickness X in the anodized film is also called "barrier layer."
The thickness of the barrier layer is determined by taking an SEM image of the cross-section of the anodized film 14 (at a magnification of 150,000X), measuring the thickness of the barrier layer in at least 25 places, and calculating the arithmetic mean of the measurements.

(Other Embodiments)

An embodiment of the lithographic printing plate support of the invention is not limited to that shown in FIG. 1. For example, another embodiment is given in which small-diameter portions 20a have a dendritic shape as shown in FIG. 2. This embodiment leads to excellent on-press developability.
In this case, the small-diameter portions 20a have one or more branching points along the depth direction. The number of branching points included in one small-diameter portion 20a is not particularly limited and is appropriately adjusted. In the case of FIG. 2, there are three branching points.
The small-diameter portions 20a in FIG. 2 each branch off into two parts at a branching point but may branch off into any number of parts. For example, the small-diameter portion 20a may branch off into three parts at a branching point.
The distance between two branching points in the depth direction (thickness direction) of the anodized film is not particularly limited and may be appropriately adjusted.
Alternatively, as still another embodiment, large-diameter portions 18b may be in a substantially conical shape (inversely tapered shape) in which the diameter increases from the surface of the anodized film toward the aluminum plate 12 as shown in FIG. 3. In other words, the diameter of the large-diameter portions 18b gradually increases from the surface of the anodized film toward the aluminum plate side. This configuration of the large-diameter portions 18b leads to a long press life.
The difference between an average diameter of the large-diameter portions 18b at the surface of the anodized film (surface layer average diameter) and an average diameter of the large-diameter portions 18b at the level of communication with the small-diameter portions 20 (bottom average diameter) is preferably at least 1 nm. When the difference is within the above-defined range, this embodiment is excellent from the viewpoint of selective sealing of the small-diameter portions. In particular, the difference is preferably at least 1 nm and more preferably 10 to 30 nm because the press life is more excellent.
The bottom shape of the large-diameter portions 18b is not particularly limited and may be curved (convex) or flat.
As yet still another embodiment, large-diameter portions 18c may have an inversely tapered shape while small-diameter portions 20c may have a dendritic shape as shown in FIG. 4.

<Lithographic Printing Plate Support Manufacturing Method>

A method of manufacturing the lithographic printing plate support according to the invention is described below.
The method of manufacturing the lithographic printing plate support of the invention is not particularly limited and a manufacturing method in which the following steps are performed in order is preferred.

(Surface roughening treatment step) Step of conducting surface roughening treatment on an aluminum plate;

(First anodizing treatment step) Step of anodizing the aluminum plate having undergone surface roughening treatment; (Pore-widening treatment step) Step of enlarging the diameter of micropores in an anodized film by bringing the aluminum plate having the anodized film obtained in the first anodizing treatment step into contact with an aqueous acid or alkali solution;
(Second anodizing treatment step) Step of anodizing the aluminum plate obtained in the pore-widening treatment step; (Third anodizing treatment step) Step of anodizing the aluminum plate obtained in the second anodizing treatment step; (Water vapor treatment step) Step of subjecting the aluminum plate obtained in the third anodizing treatment step to water vapor treatment; and

(Hydrophilizing treatment step) Step of hydrophilizing the aluminum plate after the water vapor treatment step.

The respective steps are described below in detail. The surface roughening treatment step, the pore-widening treatment step, the third anodizing treatment step and the hydrophilizing treatment step are not necessarily essential for the effects of the invention. FIG. 5 includes schematic cross-sectional views each showing a substrate and an anodized film, as arranged in order of process steps from the first anodizing treatment step to the water vapor treatment step.

<Surface Roughening Treatment Step>

The surface roughening treatment step is a step in which the surface of the aluminum plate is subjected to surface roughening treatment including electrochemical graining treatment. This step is preferably performed before the first anodizing treatment step to be described later but may not be performed if the aluminum plate already has a preferred surface profile.

The surface roughening treatment may include solely electrochemical graining treatment, or a combination of electrochemical graining treatment with mechanical graining treatment and/or chemical graining treatment.

In cases where mechanical graining treatment is combined with electrochemical graining treatment, mechanical graining treatment is preferably followed by electrochemical graining treatment.

In the practice of the invention, electrochemical graining treatment is preferably carried out in an aqueous solution of nitric acid or hydrochloric acid.

Mechanical graining treatment is generally performed in order that the surface of the aluminum plate may have a surface roughness $R_a$ of 0.35 to 1.0 $\mu$m.

In the invention, mechanical graining treatment is not particularly limited for its conditions and can be performed according to the method described in, for example, JP 50-40047 B. Mechanical graining treatment can be carried out by brush graining using a suspension of pumice or a transfer system.

Chemical graining treatment is also not particularly limited and may be carried out by any known method.

Mechanical graining treatment is preferably followed by chemical etching treatment described below.

The purpose of chemical etching treatment following mechanical graining treatment is to smooth edges of irregularities at the surface of the aluminum plate to prevent ink from catching on the edges during printing, to improve the scumming resistance of the lithographic printing plate, and to remove abrasive particles or other unnecessary substances remaining on the surface.

Chemical etching processes including etching using an acid and etching using an alkali are known, and an exemplary method which is particularly excellent in terms of etching efficiency includes chemical etching treatment using an aqueous alkali solution (hereinafter also called "alkali etching treatment").

Alkaline agents that may be used in the alkali solution are not particularly limited and illustrative examples of suitable alkaline agents include sodium hydroxide, potassium hydroxide, sodium metasilicate, sodium carbonate, sodium aluminate, and sodium gluconate.

The alkaline agents may contain aluminum ions. The alkali solution has a concentration of preferably at least 0.01 wt% and more preferably at least 3 wt%, but preferably not more than 30 wt% and more preferably not more than 25 wt%.

The temperature of the alkali solution is preferably room temperature or higher and more preferably at least 30°C, but preferably not more than 80°C and more preferably not more than 75°C.

The etching amount is preferably at least 0.1 $g/m^2$ and more preferably at least 1 $g/m^2$, but preferably not more than 20 $g/m^2$ and more preferably not more than 10 $g/m^2$.

The treatment time is preferably from 2 seconds to 5 minutes depending on the etching amount and more preferably from 2 to 10 seconds in terms of improving the productivity.

In cases where mechanical graining treatment is followed by alkali etching treatment in the invention, chemical etching treatment using an acid solution at a low temperature (hereinafter also referred to as "desmutting treatment") is preferably carried out to remove substances produced by alkali etching treatment.

Acids that may be used in the acid solution are not particularly limited and illustrative examples thereof include sulfuric acid, nitric acid and hydrochloric acid. The acid solution preferably has a concentration of 1 to 50 wt%. The acid solution preferably has a temperature of 20 to 80°C. When the concentration and temperature of the acid solution fall within the above-defined ranges, the lithographic printing plate obtained by using the lithographic printing plate support of the invention has more improved resistance to dotted scumming.

In the practice of the invention, the surface roughening treatment is a treatment in which electrochemical graining treatment is carried out after mechanical graining treatment and chemical etching treatment are carried out as desired, but also in cases where electrochemical graining treatment is carried out without performing mechanical graining treatment, electrochemical graining treatment may be preceded by chemical etching treatment using an aqueous alkali solution such as sodium hydroxide. In this way, impurities and the like which are present in the vicinity of the surface of the aluminum plate can be removed.

Electrochemical graining treatment easily forms fine irregularities (pits) at the surface of the aluminum plate and is therefore suitable to prepare a lithographic printing plate having excellent printability.

Electrochemical graining treatment is carried out in an aqueous solution containing nitric acid or hydrochloric acid as its main ingredient using direct or alternating current.

Electrochemical graining treatment is preferably followed by chemical etching treatment described below. Smut and intermetallic compounds are present at the surface of the aluminum plate having undergone electrochemical graining treatment. In chemical etching treatment following electrochemical graining treatment, it is preferable for chemical etching using an alkali solution (alkali etching treatment) to be first carried out in order to particularly remove smut with high efficiency. The conditions in chemical etching treatment using an alkali solution preferably include a treatment temperature of 20 to 80°C and a treatment time of 1 to 60 seconds. It is desirable for the alkali solution to contain aluminum ions.

In order to remove substances generated by chemical etching treatment using an alkali solution following electrochemical graining treatment, it is further preferable to carry out chemical etching treatment using an acid solution

at a low temperature (desmutting treatment).

Even in cases where electrochemical graining treatment is not followed by alkali etching treatment, desmutting treatment is preferably carried out to remove smut efficiently.

In the practice of the invention, chemical etching treatment described above is not particularly limited and may be carried out by immersion, showering, coating or other process.

<First Anodizing Treatment Step>

The first anodizing treatment step is a step in which an anodized aluminum film having micropores which extend in the depth direction (thickness direction) of the film is formed at the surface of the aluminum plate by performing anodizing treatment on the aluminum plate having undergone the above-described surface roughening treatment. As shown in FIG. 5(A), as a result of the first anodizing treatment step, an anodized aluminum film 14a bearing micropores 16a is formed at a surface of the aluminum plate 12.

The first anodizing treatment may be performed by a known method in the art but the manufacturing conditions are appropriately set so that the foregoing micropores 16 may be finally formed.

More specifically, the average diameter (average aperture diameter) of the micropores 16a formed in the first anodizing treatment step is typically from about 4 nm to about 14 nm and preferably 5 to 10 nm. At an average aperture diameter within the foregoing range, the micropores 16 having the foregoing specified shapes are easily formed and the resulting lithographic printing plate and lithographic printing plate precursor have more excellent properties.

The micropores 16a usually have a depth of about 10 nm or more but less than about 100 nm, and preferably 20 to 60 nm. At an average aperture diameter within the foregoing range, the micropores 16 having the foregoing specified shapes are easily formed and the resulting lithographic printing plate and lithographic printing plate precursor have more excellent properties.

In the first anodizing treatment step, aqueous solutions of acids such as sulfuric acid, phosphoric acid and oxalic acid may be mainly used for the electrolytic bath. An aqueous solution or non-aqueous solution containing chromic acid, sulfamic acid, benzenesulfonic acid or a combination of two or more thereof may optionally be used. The anodized film can be formed at the surface of the aluminum plate by passing direct current or alternating current through the aluminum plate in the foregoing electrolytic bath.

The electrolytic bath may contain aluminum ions. The aluminum ion content is not particularly limited and is preferably from 1 to 10 g/L.

The anodizing treatment conditions are appropriately set depending on the electrolytic solution employed. However, the following conditions are generally suitable: an electrolyte concentration of from 1 to 80 wt% (preferably from 5 to 20 wt%), a solution temperature of from 5 to 70°C (preferably from 10 to 60°C), a current density of from 0.5 to 60 $A/dm^2$ (preferably from 5 to 50 $A/dm^2$), a voltage of from 1 to 100 V (preferably from 5 to 50 V), and an electrolysis time of from 1 to 100 seconds (preferably from 5 to 60 seconds).

Of these anodizing treatment methods, the method described in GB 1,412,768 B which involves anodizing in sulfuric acid at a high current density is preferred.

<Pore-Widening Treatment Step>

The pore-widening treatment step is a step for enlarging the diameter (pore size) of the micropores present in the anodized film formed by the above-described first anodizing treatment step (pore size-enlarging treatment). As shown in FIG. 5(B), the pore-widening treatment enlarges the diameter of the micropores 16a to form an anodized film 14b bearing micropores 16b with a larger average diameter.

The pore-widening treatment increases the average diameter of the micropores 16b to a range of 10 to 60 nm (preferably 10 to 50 nm). The micropores 16b correspond to the above-described large-diameter portions 18.

The depth of the micropores 16b from the film surface is preferably adjusted by this treatment so as to be approximately the same as the depth A.

The pore-widening treatment is performed by contacting the aluminum plate obtained by the above-described first anodizing treatment step with an aqueous acid or alkali solution. Examples of the contacting method include, but are not limited to, immersion and spraying. Of these, immersion is preferred.

When the pore-widening treatment step is to be performed with an aqueous alkali solution, it is preferable to use an aqueous solution of at least one alkali selected from the group consisting of sodium hydroxide, potassium hydroxide and lithium hydroxide. The aqueous alkali solution preferably has a concentration of 0.1 to 5 wt%.

The aluminum plate is suitably contacted with the aqueous alkali solution at 10°C to 70°C (preferably 20°C to 50°C) for 1 to 300 seconds (preferably 1 to 50 seconds) after the aqueous alkali solution is adjusted to a pH of 11 to 13.

The alkaline treatment solution may contain metal salts of polyvalent weak acids such as carbonates, borates and phosphates.

When the pore-widening treatment step is to be performed with an aqueous acid solution, it is preferable to use an aqueous solution of an inorganic acid such as sulfuric acid, phosphoric acid, nitric acid or hydrochloric acid, or a mixture thereof. The aqueous acid solution preferably has a concentration of 1 to 80 wt% and more preferably 5 to 50 wt%.
The aluminum plate is suitably contacted with the aqueous acid solution at 5°C to 70°C (preferably 10°C to 60°C) for 1 to 300 seconds (preferably 1 to 150 seconds).
The aqueous alkali or acid solution may contain aluminum ions. The content of the aluminum ions is not particularly limited and is preferably from 1 to 10 g/L.

<Second Anodizing Treatment Step>

The second anodizing treatment step is a step in which micropores which further extend in the depth direction (thickness direction) of the film are formed by performing anodizing treatment on the aluminum plate having undergone the above-described pore-widening treatment. As shown in FIG. 5(C), an anodized film 14c bearing micropores 16c which extend in the depth direction of the film is formed by the second anodizing treatment step.
The second anodizing treatment step forms new pores which communicate with the bottoms of the micropores 16b with the increased average diameter, have a smaller average diameter than that of the micropores 16b (corresponding to the large-diameter portions 18) and extend from the level of communication in the depth direction. The newly formed pores correspond to the above-described small-diameter portions 20.
In the second anodizing treatment step, the treatment is performed so that the ratio (C/B) of the average diameter C of the newly formed small-diameter portions at the level of communication to the average diameter B of the large-diameter portions after the pore-widening treatment is up to 0.85 and the small-diameter portion depth from the level of communication with the corresponding large-diameter portion 18 falls within the foregoing specified range. The electrolytic bath used for the treatment is the same as used in the first anodizing treatment step and the treatment conditions are set as appropriate for the materials used.
The anodizing treatment conditions are appropriately set depending on the electrolytic solution employed. However, the following conditions are generally suitable: an electrolyte concentration of from 1 to 80 wt% (preferably from 5 to 20 wt%), a solution temperature of from 5 to 70°C (preferably from 10 to 60°C), a current density of from 0.5 to 60 $A/dm^2$ (preferably from 1 to 30 $A/dm^2$), a voltage of from 1 to 100 V (preferably from 5 to 50 V), and an electrolysis time of from 1 to 100 seconds (preferably from 5 to 60 seconds).
In the case where the dendritic small-diameter portions as shown in FIG. 2 are produced, a method may be employed in which the current density is gradually decreased in the second anodizing treatment step. In this processing, the scanning waveform shows a simple decrease pattern. The initial current density in this process varies with the type of electrolytic solution used and is often from about 10 $A/dm^2$ to about 30 $A/dm^2$.
The current density can be gradually decreased without particular limitation on the degree of decrease and is preferably decreased gradually to such an extent that the current density reduces to about 25 to 95% (preferably about 30 to 60%) of the initial value because branching points of the small-diameter portions are further increased.
The scanning time varies with the type of electrolytic solution used and is preferably about 0.1 seconds to about 30 seconds.
The anodized film obtained by the second anodizing treatment step usually has a thickness of 890 to 2,000 nm and preferably 900 to 1,500 nm. At a film thickness within the above-defined range, the lithographic printing plate precursor using the lithographic printing plate support obtained has excellent on-press developability.
The anodized film obtained by the second anodizing treatment step usually has a coating weight of 2.2 to 5.4 $g/m^2$ and preferably 2.2 to 4.0 $g/m^2$. At a coating weight within the foregoing range, the lithographic printing plate using the lithographic printing plate support obtained has a long press life, and the lithographic printing plate precursor has excellent on-press developability.
The ratio between the thickness of the anodized film obtained by the first anodizing treatment step (film thickness 1) and that of the anodized film obtained by the second anodizing treatment step (film thickness 2) (film thickness 1 / film thickness 2) is preferably from 0.01 to 0.15 and more preferably from 0.02 to 0.10. At a film thickness ratio within the foregoing range, the lithographic printing plate support has excellent scratch resistance.

<Third Anodizing Treatment Step>

The third anodizing treatment step is a step in which the aluminum plate having undergone the second anodizing treatment is further anodized to mainly increase the thickness of the anodized film located between the bottoms of the small-diameter portions and the aluminum plate (thickness of the barrier layer). In the third anodizing treatment step, the thickness of the barrier layer increases as a result of the processing at a higher current density than that in the second anodizing treatment and as shown in FIG. 5(D), the thickness X reaches a predetermined value.
When the processing is performed at a current density the same as or lower than that in the second anodizing

treatment, the micropores formed by the second anodizing treatment branch off and hence dendritic micropores are formed.

In cases where the micropores already have desired shapes at the end of the second anodizing treatment step, the third anodizing treatment step may not be performed.

The type of electrolytic solution used is not particularly limited and any of the above-described electrolytic solutions may be used. By using, for example, a boric acid-containing aqueous solution as the electrolytic bath, the thickness X can be efficiently increased without changing the shape of the small-diameter portions obtained in the second anodizing treatment step.

The anodized film obtained by the third anodizing treatment step usually has a coating weight of 0.13 to 0.65 $g/m^2$ and preferably 0.26 to 0.52 $g/m^2$. At a coating weight within the foregoing range, the lithographic printing plate using the lithographic printing plate support obtained after the foregoing steps has a long press life, excellent deinking ability after suspended printing and excellent resistance to dotted scumming, and the lithographic printing plate precursor has excellent on-press developability.

The micropores may further extend on the aluminum plate side as a result of the third anodizing treatment step.

<Water Vapor Treatment Step>

The water vapor treatment step is a step in which the aluminum plate after the second anodizing treatment step is brought into contact with water vapor.

The water vapor used in the water vapor treatment step has a temperature of at least 150°C but less than 300°C.

The aluminum oxide forming the small-diameter portions reacts with water in the water vapor treatment step and as shown in FIG. 5(E), the boehmite protrusions 100 grow from the side surfaces of the small-diameter portions in the direction of the average diameter C of the small-diameter portions. Thus an anodized film 14e bearing micropores 16e sealed with the boehmite protrusions is formed.

At a water vapor temperature of less than 150°C, the ratio (k/B) between the average height k of the boehmite protrusions generated inside the large-diameter portions and the average diameter B of the large-diameter portions exceeds 0.27, and the lithographic printing plate precursor obtained using such a lithographic printing plate support has poor on-press developability.

At a water vapor temperature of 300°C or more, the inside of the small-diameter portions is dried so that boehmite is not generated inside the small-diameter portions and therefore, the lithographic printing plate support of the invention cannot be obtained.

The water vapor for use in water vapor treatment preferably has a temperature of 150 to 240°C and more preferably 170 to 230°C because more excellent resistance to dotted scumming is achieved.

The water vapor for use in water vapor treatment preferably has a pressure of 0.3 to 1 atm and more preferably 0.5 to 1 atm because more excellent resistance to dotted scumming is achieved.

The water vapor treatment time is preferably at least 1 second, more preferably at least 3 seconds, even more preferably 7 seconds and still even more preferably at least 15 seconds because more excellent resistance to dotted scumming is achieved. The upper limit of the treatment time is not particularly limited and is preferably up to 1 minute and more preferably up to 30 seconds in terms of the productivity.

The method of bringing the aluminum plate into contact with water vapor in water vapor treatment is not particularly limited and exemplary methods include a method in which the aluminum plate is caused to run through a box that is filled with water vapor produced by a boiling water method; and a method in which water vapor is directly sprayed onto the aluminum plate through a steam nozzle.

<Hydrophilizing Treatment Step>

The method of manufacturing the lithographic printing plate support of the invention may have a hydrophilizing treatment step in which the aluminum plate is hydrophilized after the above-described water vapor treatment step. Hydrophilizing treatment may be performed by the known method disclosed in paragraphs [0109] to [0114] of JP 2005-254638 A.

It is preferable to perform hydrophilizing treatment by a method in which the aluminum plate is immersed in an aqueous solution of an alkali metal silicate such as sodium silicate or potassium silicate, or is coated with a hydrophilic vinyl polymer or a hydrophilic compound so as to form a hydrophilic undercoat.

Hydrophilizing treatment with an aqueous solution of an alkali metal silicate such as sodium silicate or potassium silicate can be carried out according to the processes and procedures described in US 2,714,066 and US 3,181,461.

<Drying Step>

After the lithographic printing plate support is obtained by the above-described steps, a treatment for drying the surface of the lithographic printing plate support (drying step) is preferably performed before providing an image recording layer to be described later thereon.
Drying is preferably performed after the support having undergone the last surface treatment is rinsed with water and the water is removed with nip rollers. Specific conditions are not particularly limited but the surface of the lithographic printing plate support is preferably dried by hot air (50°C to 200°C) or natural air.

<Lithographic Printing Plate Precursor>

The lithographic printing plate precursor of the invention can be obtained by forming an image recording layer such as a photosensitive layer or a thermosensitive layer exemplified below on the lithographic printing plate support of the invention. The type of the image recording layer is not particularly limited but the image recording layers of conventional positive type, conventional negative type, photopolymer type, thermal positive type, thermal negative type and on-press developable non-processing type as described in paragraphs [0042] to [0198] of JP 2003-1956 A, for instance, are suitably used.
A preferred image recording layer is described below in detail.

<Image Recording Layer>

The image recording layer which is suitably used for the lithographic printing plate precursor of the invention is preferably an image recording layer removable by printing ink and/or fountain solution, that is to say, the image recording layer which includes an infrared absorbent, a polymerization initiator and a polymerizable compound and is thus ready to record thereon by infrared irradiation.
In the lithographic printing plate precursor of the invention, irradiation with infrared light cures exposed portions of the image recording layer to form hydrophobic (lipophilic) regions, while at the start of printing, unexposed portions are promptly removed from the support by fountain solution, ink, or an emulsion of ink and fountain solution.
The constituents of the image recording layer are described below.

(Infrared Absorber)

In cases where an image is formed on the lithographic printing plate precursor of the invention using a laser emitting infrared light at 760 to 1200 nm as a light source, an infrared absorber is usually used.
The infrared absorbent has the function of converting absorbed infrared light into heat and, as being excited by the infrared light, performs electron transfer/energy transfer to the polymerization initiator (radical generator) to be described below.
The infrared absorber that may be used in the invention is a dye or pigment having an absorption maximum in a wavelength range of 760 to 1200 nm.
Dyes which may be used include commercial dyes and known dyes that are mentioned in the technical literature, such as "Senryo Binran" [Handbook of Dyes] (The Society of Synthetic Organic Chemistry, Japan, 1970).
Illustrative examples of suitable dyes include azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal-thiolate complexes. For example, dyes disclosed in paragraphs [0096] to [0107] of JP 2009-255434 A can be advantageously used.
On the other hand, pigments described, for example, in paragraphs [0108] to [0112] of JP 2009-255434 A may be used.

(Polymerization Initiator)

Exemplary polymerization initiators which may be used are compounds that generate a radical under light or heat energy or both, and initiate or promote the polymerization of a compound having a polymerizable unsaturated group. In the invention, compounds that generate a radical under the action of heat (thermal radical generators) are preferably used.
Known thermal polymerization initiators, compounds having a bond with small bond dissociation energy and photopolymerization initiators may be used as the polymerization initiator.
For example, polymerization initiators described in paragraphs [0115] to [0141] of JP 2009-255434 A may be used.

Onium salts may be used as the polymerization initiator, and oxime ester compounds, diazonium salts, iodonium salts and sulfonium salts are preferred in terms of reactivity and stability.

These polymerization initiators may be added in an amount of 0.1 to 50 wt%, preferably 0.5 to 30 wt% and most preferably 1 to 20 wt% with respect to the total solids making up the image recording layer. An excellent sensitivity and high resistance to scumming in non-image areas during printing are achieved at a polymerization initiator content within the above-defined range.

(Polymerizable Compound)

Polymerizable compounds are addition polymerizable compounds having at least one ethylenically unsaturated double bond, and are selected from compounds having at least one, and preferably two or more, terminal ethylenically unsaturated bonds. In the invention, use can be made of any addition polymerizable compound known in the prior art, without particular limitation.

For example, polymerizable compounds described in paragraphs [0142] to [0163] of JP 2009-255434 A may be used.

Addition polymerizable urethane compounds produced using an addition reaction between an isocyanate group and a hydroxyl group are also suitable. Specific examples include the vinylurethane compounds having two or more polymerizable vinyl groups in the molecule that are obtained by adding a hydroxyl group-bearing vinyl monomer of the general formula (A) below to the polyisocyanate compounds having two or more isocyanate groups in the molecule mentioned in JP 48-41708 B:

$$CH_2{=}C(R^4)COOCH_2CH(R^5)OH \qquad (A)$$

(wherein $R^4$ and $R^5$ are H or $CH_3$).

The polymerizable compound is used in an amount of preferably 5 to 80 wt%, and more preferably 25 to 75 wt% with respect to the nonvolatile ingredients in the image recording layer. These addition polymerizable compounds may be used singly or in combination of two or more thereof.

(Binder Polymer)

In the practice of the invention, use may be made of a binder polymer in the image recording layer in order to improve the film forming properties of the image recording layer.

Conventionally known binder polymers may be used without any particular limitation and polymers having film forming properties are preferred. Examples of such binder polymers include acrylic resins, polyvinyl acetal resins, polyurethane resins, polyurea resins, polyimide resins, polyamide resins, epoxy resins, methacrylic resins, polystyrene resins, novolac-type phenolic resins, polyester resins, synthetic rubbers and natural rubbers.

Crosslinkability may be imparted to the binder polymer to enhance the film strength in image areas. To impart crosslinkability to the binder polymer, a crosslinkable functional group such as an ethylenically unsaturated bond may be introduced into the polymer main chain or side chain. The crosslinkable functional groups may be introduced by copolymerization.

Binder polymers disclosed in paragraphs [0165] to [0172] of JP 2009-255434 A may also be used.

The binder polymer content is from 5 to 90 wt%, preferably from 5 to 80 wt% and more preferably from 10 to 70 wt% based on the total solids in the image recording layer. A high strength in image areas and good image forming properties are achieved at a binder polymer content within the above-defined range.

The polymerizable compound and the binder polymer are preferably used at a weight ratio of 0.5/1 to 4/1.

(Surfactant)

A surfactant is preferably used in the image recording layer in order to promote the on-press developability at the start of printing and improve the coated surface state.

Exemplary surfactants include nonionic surfactants, anionic surfactants, cationic surfactants, amphoteric surfactants and fluorosurfactants.

For example, surfactants disclosed in paragraphs [0175] to [0179] of JP 2009-255434 A may be used.

Use may be made of a single surfactant or of a combination of two or more surfactants.

The surfactant content is preferably from 0.001 to 10 wt%, and more preferably from 0.01 to 5 wt% with respect to the total solids in the image recording layer.

Various other compounds than those mentioned above may optionally be added to the image recording layer. For example, compounds disclosed in paragraphs [0181] to [0190] of JP 2009-255434 A such as colorants, printing-out

agents, polymerization inhibitors, higher fatty acid derivatives, plasticizers, inorganic fine particles and low-molecular-weight hydrophilic compounds may be used.

<Formation of Image Recording Layer>

The image recording layer is formed by dispersing or dissolving the necessary ingredients described above in a solvent to prepare a coating liquid and applying the thus prepared coating liquid to the support. Examples of the solvent that may be used include, but are not limited to, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate and water.
These solvents may be used alone or as mixtures of two or more thereof. The coating liquid has a solids concentration of preferably 1 to 50 wt%.
The image recording layer coating weight (solids content) on the lithographic printing plate support obtained after coating and drying varies depending on the intended application, although an amount of 0.3 to 3.0 g/$m^2$ is generally preferred. At an image recording layer coating weight within this range, a good sensitivity and good image recording layer film properties are obtained.
Examples of suitable methods of coating include bar coating, spin coating, spray coating, curtain coating, dip coating, air knife coating, blade coating and roll coating.

<Undercoat>

In the lithographic printing plate precursor of the invention, it is desirable to provide an undercoat between the image recording layer and the lithographic printing plate support.
The undercoat preferably contains a polymer having a substrate adsorbable group, a polymerizable group and a hydrophilic group.
An example of the polymer having a substrate adsorbable group, a polymerizable group and a hydrophilic group includes an undercoating polymer resin obtained by copolymerizing an adsorbable group-bearing monomer, a hydrophilic group-bearing monomer and a polymerizable reactive group (crosslinkable group)-bearing monomer.
Monomers described in paragraphs [0197] to [0210] of JP 2009-255434 A, for example, may be used for the undercoating polymer resin.
Various known methods may be used to apply the undercoat-forming coating liquid containing the constituents of the undercoat to the support. Examples of suitable methods of application include bar coating, spin coating, spray coating, curtain coating, dip coating, air knife coating, blade coating and roll coating.
The coating weight (solids content) of the undercoat is preferably from 0.1 to 100 mg/$m^2$ and more preferably from 1 to 50 mg/$m^2$.

<Protective Layer>

In the lithographic printing plate precursor of the invention, the image recording layer may optionally have a protective layer formed thereon to prevent scuffing and other damage to the image recording layer, to serve as an oxygen barrier, and to prevent ablation during exposure to a high-intensity laser.
The protective layer has heretofore been variously studied and is described in detail in, for example, US 3,458,311 and JP 55-49729 B.
Exemplary materials that may be used for the protective layer include those described, for example, in paragraphs [0213] to [02227] of JP 2009-255434 A (e.g., water-soluble polymer compounds and inorganic layered compounds).
The thus prepared protective layer-forming coating liquid is applied onto the image recording layer provided on the support and dried to form the protective layer. The coating solvent may be selected as appropriate in connection with the binder, but distilled water and purified water are preferably used in cases where a water-soluble polymer is employed. Examples of the coating method used to form the protective layer include, but are not limited to, blade coating, air knife coating, gravure coating, roll coating, spray coating, dip coating and bar coating.
The coating weight after drying of the protective layer is preferably from 0.01 to 10 g/$m^2$, more preferably from 0.02 to 3 g/$m^2$, and most preferably from 0.02 to 1 g/$m^2$.
The inventive lithographic printing plate precursor having the image recording layer as described above exhibits a long press life in the lithographic printing plate formed therefrom and exhibits improved on-press developability in the case of an on-press developing type.

EXAMPLES

The invention is described in detail by way of Examples. However, the invention should not be construed as being limited to the following Examples.

<Manufacture of Lithographic Printing Plate Support>

Aluminum alloy plates of material type 1S with a thickness of 0.3 mm were subjected to the treatments (A) to (O) to be described below to manufacture lithographic printing plate supports. Rinsing treatment was performed between every two treatment steps and the water remaining after rinsing treatment was removed with nip rollers.

(A) Mechanical graining treatment (brush graining)

Mechanical graining treatment was performed with rotating bristle bundle brushes of an apparatus as shown in FIG. 8 while feeding an abrasive slurry in the form of a suspension of pumice (specific gravity: 1.1 g/cm$^3$) to the surface of the aluminum plate. FIG. 8 shows an aluminum plate 1, roller brushes (bristle bundle brushes in Examples) 2 and 4, an abrasive slurry 3, and support rollers 5, 6, 7 and 8.

Mechanical graining treatment was carried out using an abrasive having a median diameter (μm) of 30 μm while rotating four brushes at a rotational speed (rpm) of 250 rpm. The bristle bundle brushes were made of nylon 6/10 and had a bristle diameter of 0.3 mm and a bristle length of 50 mm. Each brush was constructed of a 300 mm diameter stainless steel cylinder in which holes had been formed and bristles densely set. Two support rollers (200 mm diameter) were provided below each bristle bundle brush and spaced 300 mm apart. The bundle bristle brushes were pressed against the aluminum plate until the load on the driving motor that rotates the brushes was greater by 10 kW than before the bundle bristle brushes were pressed against the plate. The direction in which the brushes were rotated was the same as the direction in which the aluminum plate was moved.

(B) Alkali etching treatment

Etching treatment was performed by using a spray line to spray the aluminum plate obtained as described above with an aqueous solution having a sodium hydroxide concentration of 26 wt%, an aluminum ion concentration of 6.5 wt%, and a temperature of 70°C. The plate was then rinsed by spraying with water. The amount of dissolved aluminum was 10 g/m$^2$.

(C) Desmutting treatment in aqueous acid solution

Next, desmutting treatment was performed in an aqueous nitric acid solution. The nitric acid wastewater from the subsequent electrochemical graining treatment step was used for the aqueous nitric acid solution in desmutting treatment. The solution temperature was 35°C. Desmutting treatment was performed by spraying the plate with the desmutting solution for 3 seconds.

(D) Electrochemical graining treatment

Electrochemical graining treatment was consecutively carried out by nitric acid electrolysis using a 60 Hz AC voltage. Aluminum nitrate was added to an aqueous solution containing 10.4 g/L of nitric acid at a temperature of 35°C to prepare an electrolytic solution having an adjusted aluminum ion concentration of 4.5 g/L, and the electrolytic solution was used in electrochemical graining treatment. The AC source current waveform was as shown in FIG. 6 and electrochemical graining treatment was performed for a period of time tp until the current reached a peak from zero of 0.8 ms, at a duty ratio of 1:1, using an alternating current having a trapezoidal waveform, and with a carbon electrode as the counter electrode. A ferrite was used for the auxiliary anode. An electrolytic cell of the type shown in FIG. 7 was used. The current density at the current peak was 30 A/dm$^2$. Of the current that flows from the power supply, 5% was diverted to the auxiliary anodes. The amount of electricity (C/dm$^2$), which is the total amount of electricity when the aluminum plate serves as an anode, was 185 C/dm$^2$. The plate was then rinsed by spraying with water.

(E) Alkali etching treatment

Etching treatment was performed by using a spray line to spray the aluminum plate obtained as described above with an aqueous solution having a sodium hydroxide concentration of 5 wt%, an aluminum ion concentration of 0.5 wt%, and a temperature of 50°C. The plate was then rinsed by spraying with water. The amount of dissolved aluminum

was 0.5 g/$m^2$.

(F) Desmutting treatment in aqueous acid solution

Next, desmutting treatment was performed in an aqueous sulfuric acid solution. The aqueous sulfuric acid solution used in desmutting treatment was a solution having a sulfuric acid concentration of 170 g/L and an aluminum ion concentration of 5 g/L. The solution temperature was 60°C. Desmutting treatment was performed by spraying the plate with the desmutting solution for 3 seconds.

(G) Electrochemical graining treatment

Electrochemical graining treatment was consecutively carried out by hydrochloric acid electrolysis using a 60 Hz AC voltage. Aluminum chloride was added to an aqueous solution containing 6.2 g/L of hydrochloric acid at a temperature of 35°C to prepare an electrolytic solution having an adjusted aluminum ion concentration of 4.5 g/L, and the electrolytic solution was used in electrochemical graining treatment. The AC source current waveform was as shown in FIG. 6 and electrochemical graining treatment was performed for a period of time tp until the current reached a peak from zero of 0.8 ms, at a duty ratio of 1:1, using an alternating current having a trapezoidal waveform, and with a carbon electrode as the counter electrode. A ferrite was used for the auxiliary anode. An electrolytic cell of the type shown in FIG. 7 was used.

The current density at the current peak was 25 A/$dm^2$. The amount of electricity (C/$dm^2$) in hydrochloric acid electrolysis, which is the total amount of electricity when the aluminum plate serves as an anode, was 63 C/$dm^2$. The plate was then rinsed by spraying with water.

(H) Alkali etching treatment

Etching treatment was performed by using a spray line to spray the aluminum plate obtained as described above with an aqueous solution having a sodium hydroxide concentration of 5 wt%, an aluminum ion concentration of 0.5 wt%, and a temperature of 50°C. The plate was then rinsed by spraying with water. The amount of dissolved aluminum was 0.1 g/$m^2$.

(I) Desmutting treatment in aqueous acid solution

Next, desmutting treatment was performed in an aqueous sulfuric acid solution. More specifically, wastewater generated in the anodizing treatment step (aqueous solution containing 170 g/L of sulfuric acid and 5 g/L of aluminum ions dissolved therein) was used to perform desmutting treatment at a solution temperature of 35°C for 4 seconds. Desmutting treatment was performed by spraying the plate with the desmutting solution for 3 seconds.

(J) First anodizing treatment

The first anodizing treatment was performed by DC electrolysis using an anodizing apparatus of the structure as shown in FIG. 9. The anodizing treatment was performed under the conditions shown in Table 1 to form the anodized film with a specified film thickness.

In an anodizing apparatus 610, an aluminum plate 616 is transported as shown by arrows in FIG. 9. The aluminum plate 616 is positively (+) charged by a power supply electrode 620 in a power supply cell 612 containing an electrolytic solution 618. The aluminum plate 616 is then transported upward by a roller 622 disposed in the power supply cell 612, turned downward by nip rollers 624 and transported toward an electrolytic cell 614 containing an electrolytic solution 626 to be turned to a horizontal direction by a roller 628. Then, the aluminum plate 616 is negatively (-) charged by an electrolytic electrode 630 to form an anodized film on the plate surface. The aluminum plate 616 emerging from the electrolytic cell 614 is then transported to the section for the subsequent step. In the anodizing apparatus 610, the roller 622, the nip roller 624 and the roller 628 constitute direction changing means, and the aluminum plate 616 is transported through the power supply cell 612 and the electrolytic cell 614 in a mountain shape and a reversed U shape by means of these rollers 622, 624 and 628. The power supply electrode 620 and the electrolytic electrode 630 are connected to a DC power supply 634.

(K) Pore-widening treatment

Pore-widening treatment was performed by immersing the aluminum plate anodized by the above-described first anodizing treatment in an aqueous solution having a sodium hydroxide concentration of 5 wt% and an aluminum

ion concentration of 0.5 wt% under the conditions shown in Table 1. The plate was then rinsed by spraying with water.

The pore-widening treatment was not performed in Example 21.

(L) Second anodizing treatment

The second anodizing treatment was performed by DC electrolysis using an anodizing apparatus of the structure as shown in FIG. 9. The anodizing treatment was performed under the conditions shown in Table 1 to form the anodized film with a specified film thickness.

(M) Third anodizing treatment

The third anodizing treatment was performed by DC electrolysis using an anodizing apparatus of the structure as shown in FIG. 9. The anodizing treatment was performed under the conditions shown in Table 1 to form the anodized film with a specified film thickness.

The third anodizing treatment was performed only in Examples 13, 21 and 22.

(N) Water vapor treatment

After the second anodizing treatment, the aluminum plate obtained as described above was subjected to water vapor treatment under the water vapor temperature (Temp [°C]), the treatment time (Time [sec]) and the pressure condition (Pressure [atm]) as shown in Table 1. Water vapor treatment was performed by putting the aluminum plate into a box filled with vapor so that the aluminum plate was brought into contact with vapor. The temperature and pressure condition of water vapor were measured in the box. In the case where water vapor treatment was not performed, the fields of "Temp", "Time" and "Pressure" were filled with "-."

(O) Silicate treatment

In order to ensure the hydrophilicity in non-image areas, silicate treatment was performed by dipping the plate into an aqueous solution containing 2.5 wt% of No. 3 sodium silicate at 50°C for 7 seconds. The amount of deposited silicon was 10 mg/$m^2$. The plate was then rinsed by spraying with water.

As to each lithographic printing plate support obtained by the foregoing treatments (A) to (O), the depth A of the large-diameter portions, the average diameter B of the large-diameter portions, the average height k of the protrusions inside the large-diameter portions, k/B, the depth of the small-diameter portions, the average diameter C of the small-diameter portions, C/B, the average height h of the boehmite protrusions inside the small-diameter portions, h/C, the sealing ratio, and the thickness of the barrier layer are shown below in Table 2.

The micropores in Examples 1 to 20 and Comparative Examples 1 and 3 to 9 were formed so that the large-diameter portions and the small-diameter portions had a straight tubular shape as shown in FIG. 1. The micropores in Example 21 were formed so that the large-diameter portions had an inversely tapered shape (the bottom average diameter being about twice as large as the surface layer average diameter) and the small-diameter portions had a dendritic shape as shown in FIG. 4. The micropores in Example 22 were formed so that the large-diameter portions had a straight tubular shape and the small-diameter portions had a dendritic shape as shown in FIG. 2. The micropores in Comparative Example 2 were composed only of the large-diameter portions having a straight tubular shape.

(Average Diameter of Micropores)

The average diameter of the large-diameter portions of the micropores was determined as follows: Surfaces of the large-diameter portions were observed with FE-SEM at a magnification of 150,000X to obtain four images (N = 4), in the resulting four images, the diameter of the large-diameter portions of the micropores within an area of 400 x 600 $nm^2$ was measured, and the arithmetic mean of the measurements was calculated.

The average diameter of the small-diameter portions of the micropores was determined as follows: The cross-section of the anodized film was observed with FE-TEM at a magnification of 500,000X, the diameter of the small-diameter portions of 60 (N = 60) micropores (the diameter at the level of communication with the corresponding large-diameter portions of the micropores) was measured, and the arithmetic mean of the measurements was calculated. The cross-section of the anodized film was observed by cutting the anodized film by FIB to prepare a thin film (about 50 nm).

(Depth of Micropores)

The depth of the large-diameter portions of the micropores was determined as follows: The cross-section of

the support (anodized film) was taken by FE-TEM at a magnification of 500,000X for observation, in the resulting image, the depth of arbitrarily selected 25 micropores was measured, and the arithmetic mean of the measurements was calculated.

The depth of the small-diameter portions of the micropores was determined as follows: The cross-section of the support (anodized film) was taken by FE-SEM at a magnification of 50,000X for observation, in the resulting image, the depth of arbitrarily selected 25 micropores was measured, and the arithmetic mean of the measurements was calculated.

The cross-section of the anodized film was observed by cutting the anodized film by FIB to prepare a thin film (about 50 nm).

(Average Height h, k of Boehmite Protrusions)

The average height h of the boehmite protrusions was determined as follows: The lithographic printing plate support was cut by FIB to prepare an ultrathin section, the ultrathin section was observed with FE-TEM (at a magnification of 800,000X), the maximum height (height h) from the top to the bottom of each boehmite protrusion inside 25 small-diameter portions was measured, and the arithmetic mean of the measurements was calculated.

In the same manner, the average height k of the boehmite protrusions was determined as follows: The lithographic printing plate support was cut by FIB to prepare an ultrathin section, the ultrathin section was observed with FE-TEM (at a magnification of 800,000X), the maximum height (height k) from the top to the bottom of each boehmite protrusion inside 25 large-diameter portions was measured, and the arithmetic mean of the measurements was calculated.

(Sealing Ratio)

The sealing ratio was determined as follows:

First, the supports having micropores each composed of the large-diameter portion and the small-diameter portion were subjected to sealing treatment, and a specific surface area p1 before sealing and a specific surface area p2 after sealing of each support were measured.

Next, the support having micropores composed only of the large-diameter portions was prepared and subjected to sealing treatment under the same conditions as above, and a specific surface area q1 of the support before sealing and a specific surface area q2 of the same after sealing were measured.

A specific surface area of the small-diameter portions before sealing is expressed by p1 - q1. A specific surface area of the small-diameter portions after sealing is expressed by p2 - q2.

The sealing ratio was determined from the obtained specific surface areas in accordance with the following equation.

$$(\text{Sealing ratio } (\%)) = [\{(p1 - q1) - (p2 - q2)\} / (p1 - q1)] \times 100$$

The specific surface areas are determined by BET method with the use of nitrogen adsorption as measured.

(Barrier Layer Thickness)

The thickness of the anodized film (barrier layer thickness) from the bottom of the small-diameter portions to the aluminum plate surface was determined by taking an SEM image of the cross-section of the anodized film 14 (at a magnification of 150,000X), measuring the thickness (of the barrier layer) in 25 places, and calculating the arithmetic mean of the measurements.

[Table 1]

Table 1

| | First anodizing treatment | | | | | | Pore-widening treatment | | | | | | Second anodizing treatment | | | | | | Third anodizing treatment | | | | | | Superheated water vapor | | |
|---|---|---|---|---|---|---|---|---|---|---|---|---|---|---|---|---|---|---|---|---|---|---|---|---|---|---|---|
| | Liquid type | Liquid component | Concentration | Temp | Current density | Film thickness | Liquid type | Liquid component | Concentration | Temp | Treatment time | Liquid type | Liquid component | Concentration | Temp | Current density | Film thickness | Liquid type | Liquid component | Concentration | Temp | Current density | Film thickness | Temp | Treatment time | Pressure |
| | | | g/L | °C | $A/dm^2$ | nm | | | wt.% | °C | sec | | | g/L | °C | $A/dm^2$ | nm | | | g/L | °C | $A/dm^2$ | nm | °C | sec | atm |
| EX 1 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 150 | 1 | 1 |
| EX 2 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 150 | 5 | 1 |
| EX 3 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 150 | 10 | 1 |
| EX 4 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 150 | 20 | 1 |
| EX 5 | Sulfuric acid | $H_2SO_4/Al$ | 170/5 | 43 | 30 | 50 | Sodium hydroxide | NaOH/Al | 5/0.5 | 35 | 20 | Sulfuric acid | $H_2SO_4/Al$ | 170/5 | 43 | 15 | 950 | - | - | - | - | - | | 150 | 10 | 1 |
| EX 6 | Sulfuric acid | $H_2SO_4/Al$ | 170/5 | 43 | 30 | 55 | Sodium hydroxide | NaOH/Al | 5/0.5 | 35 | 6 | Sulfuric acid | $H_2SO_4/Al$ | 170/5 | 43 | 15 | 945 | - | - | - | - | - | | 150 | 10 | 1 |
| EX 7 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 100/5 | 56 | 15 | 950 | - | - | - | - | - | | 150 | 10 | 1 |
| EX 8 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 100/5 | 56 | 15 | 950 | - | - | - | - | - | | 150 | 20 | 1 |
| EX 9 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 200 | 1 | 1 |
| EX 10 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 200 | 5 | 1 |
| EX 11 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 200 | 10 | 1 |
| EX 12 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 250 | 10 | 1 |
| EX 13 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 920 | Sulfuric acid | $H_2SO_4/Al$ | 130/5 | 30 | 50 | 30 | 150 | 10 | 1 |
| EX 14 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 150 | 10 | 1 |
| EX 15 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 150 | 10 | 1 |
| EX 16 | Sulfuric acid | $H_2SO_4/Al$ | 170/5 | 43 | 30 | 50 | Sodium hydroxide | NaOH/Al | 5/0.5 | 35 | 1 | Sulfuric acid | $H_2SO_4/Al$ | 170/5 | 43 | 15 | 950 | - | - | - | - | - | | 150 | 10 | 1 |
| EX 17 | Sulfuric acid | $H_2SO_4/Al$ | 170/5 | 43 | 30 | 12 | Sodium hydroxide | NaOH/Al | 5/0.5 | 35 | 6 | Sulfuric acid | $H_2SO_4/Al$ | 170/5 | 43 | 15 | 988 | - | - | - | - | - | | 150 | 10 | 1 |
| EX 18 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 1950 | - | - | - | - | - | | 150 | 10 | 1 |
| EX 19 | Sulfuric acid | $H_2SO_4/Al$ | 170/5 | 43 | 30 | 60 | Sodium hydroxide | NaOH/Al | 5/0.5 | 35 | 6 | Sulfuric acid | $H_2SO_4/Al$ | 170/5 | 43 | 15 | 940 | - | - | - | - | - | | 150 | 10 | 1 |
| EX 20 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 150 | 10 | 1 |
| EX 21 | Sulfuric acid | $H_2SO_4/Al$ | 170/5 | 32 | 55 | 45 | - | - | - | - | - | Sulfuric acid | $H_2SO_4/Al$ | 300/5 | 60 | 15 | 855 | Sulfuric acid | $H_2SO_4/Al$ | 170/5 | 43 | 15 | 100 | 150 | 10 | 1 |
| EX 22 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 850 | Sulfuric acid | $H_2SO_4/Al$ | 170/5 | 43 | 12 | 100 | 150 | 10 | 1 |
| CE 1 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | - | - | - |
| CE 2 | Sulfuric acid | $H_2SO_4/Al$ | 170/5 | 43 | 30 | 50 | Sodium hydroxide | NaOH/Al | 5/0.5 | 35 | 6 | - | - | - | - | - | - | - | - | - | - | - | | 150 | 10 | 1 |
| CE 3 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 145 | 10 | 1 |
| CE 4 | Sulfuric acid | $H_2SO_4/Al$ | 170/5 | 43 | 30 | 50 | Sodium hydroxide | NaOH/Al | 5/0.5 | 20 | 2 | Sulfuric acid | $H_2SO_4/Al$ | 170/5 | 43 | 15 | 950 | - | - | - | - | - | | 150 | 10 | 1 |
| CE 5 | Sulfuric acid | $H_2SO_4/Al$ | 170/5 | 43 | 30 | 50 | Sodium hydroxide | NaOH/Al | 5/0.5 | 35 | 22 | Sulfuric acid | $H_2SO_4/Al$ | 170/5 | 43 | 15 | 950 | - | - | - | - | - | | 150 | 10 | 1 |
| CE 6 | Sulfuric acid | $H_2SO_4/Al$ | 170/5 | 43 | 30 | 65 | Sodium hydroxide | NaOH/Al | 5/0.5 | 35 | 6 | Sulfuric acid | $H_2SO_4/Al$ | 170/5 | 43 | 15 | 935 | - | - | - | - | - | | 150 | 10 | 1 |
| CE 7 | Sulfuric acid | $H_2SO_4/Al$ | 170/5 | 43 | 30 | 50 | Sodium hydroxide | NaOH/Al | 5/0.5 | 35 | 6 | Sulfuric acid | $H_2SO_4/Al$ | 170/5 | 43 | 15 | 950 | - | - | - | - | - | | 300 | 10 | 1 |
| CE 8 | Sulfuric acid | $H_2SO_4/Al$ | 170/5 | 43 | 30 | 4 | Sodium hydroxide | NaOH/Al | 5/0.5 | 35 | 6 | Sulfuric acid | $H_2SO_4/Al$ | 170/5 | 43 | 15 | 996 | - | - | - | - | - | | 150 | 10 | 1 |
| CE 9 | Sulfuric acid | $H_2SO_4/Al$ | 170/5 | 43 | 30 | 25 | Sodium hydroxide | NaOH/Al | 5/0.5 | 35 | 6 | Sulfuric acid | $H_2SO_4/Al$ | 50/5 | 65 | 15 | 975 | - | - | - | - | - | | 150 | 10 | 1 |

[Table 2]

Table 2

| | Aluminum plate | Anodized film | | | | | | | | | | Barrier layer |
|---|---|---|---|---|---|---|---|---|---|---|---|---|
| | | Large-diameter portion | | | | Small-diameter portion | | | | | | |
| | Al-Fe intermetallic compound content (wt%) | Average diameter B (nm) | Depth A (nm) | Average height k of protrusions (nm) | k/B | Average diameter C (nm) | C/B | Depth (nm) | Average height h of protrusions (nm) | h/C | Sealing ratio (%) | Thickness (nm) |
| EX 1 | 0.045 | 25 | 50 | 0.0 | 0.00 | 8 | 0.32 | 950 | 2.4 | 0.3 | 5 | 25 |
| EX 2 | 0.045 | 25 | 50 | 1.0 | 0.04 | 8 | 0.32 | 950 | 4.0 | 0.5 | 30 | 25 |
| EX 3 | 0.045 | 25 | 50 | 3.0 | 0.12 | 8 | 0.32 | 950 | 6.4 | 0.8 | 70 | 25 |
| EX 4 | 0.045 | 25 | 50 | 5.0 | 0.20 | 8 | 0.32 | 950 | 8.0 | 1.0 | 85 | 25 |
| EX 5 | 0.045 | 60 | 50 | 3.0 | 0.05 | 8 | 0.13 | 950 | 6.4 | 0.8 | 70 | 25 |
| EX 6 | 0.045 | 25 | 55 | 3.0 | 0.12 | 8 | 0.32 | 945 | 6.4 | 0.8 | 70 | 25 |
| EX 7 | 0.045 | 25 | 50 | 3.0 | 0.12 | 16 | 0.64 | 950 | 6.4 | 0.4 | 20 | 25 |
| EX 8 | 0.045 | 25 | 50 | 3.0 | 0.12 | 16 | 0.64 | 950 | 9.6 | 0.6 | 50 | 25 |
| EX 9 | 0.045 | 25 | 50 | 0.0 | 0.00 | 8 | 0.32 | 950 | 3.2 | 0.4 | 20 | 25 |
| EX 10 | 0.045 | 25 | 50 | 0.0 | 0.00 | 8 | 0.32 | 950 | 5.6 | 0.7 | 60 | 25 |
| EX 11 | 0.045 | 25 | 50 | 1.0 | 0.04 | 8 | 0.32 | 950 | 7.2 | 0.9 | 85 | 25 |
| EX 12 | 0.045 | 25 | 50 | 0.0 | 0.00 | 8 | 0.32 | 950 | 3.2 | 0.4 | 20 | 25 |
| EX 13 | 0.045 | 25 | 50 | 3.0 | 0.12 | 8 | 0.32 | 950 | 6.4 | 0.8 | 70 | 35 |

(continued)

| | Aluminum plate | Anodized film | | | | | | | | | | Barrier layer |
|---|---|---|---|---|---|---|---|---|---|---|---|---|
| | | Large-diameter portion | | | | Small-diameter portion | | | | | | |
| | Al-Fe intermetallic compound content (wt%) | Average diameter B (nm) | Depth A (nm) | Average height k of protrusions (nm) | k/B | Average diameter C (nm) | C/B | Depth (nm) | Average height h of protrusions (nm) | h/C | Sealing ratio (%) | Thickness (nm) |
| EX 14 | 0.065 | 25 | 50 | 3.0 | 0.12 | 8 | 0.32 | 950 | 6.4 | 0.8 | 70 | 25 |
| EX 15 | 0.010 | 25 | 50 | 3.0 | 0.12 | 8 | 0.32 | 950 | 6.4 | 0.8 | 70 | 25 |
| EX 16 | 0.045 | 12 | 50 | 3.0 | 0.25 | 8 | 0.67 | 950 | 6.4 | 0.8 | 70 | 25 |
| EX 17 | 0.045 | 25 | 12 | 3.0 | 0.12 | 8 | 0.32 | 988 | 6.4 | 0.8 | 70 | 25 |
| EX 18 | 0.045 | 25 | 50 | 3.0 | 0.12 | 8 | 0.32 | 1950 | 6.4 | 0.8 | 70 | 25 |
| EX 19 | 0.045 | 25 | 60 | 3.0 | 0.12 | 8 | 0.32 | 940 | 6.4 | 0.8 | 70 | 25 |
| EX 20 | 0.060 | 25 | 50 | 3.0 | 0.12 | 8 | 0.32 | 950 | 6.4 | 0.8 | 70 | 25 |
| EX 21 | 0.045 | 14 | 45 | 3.0 | 0.21 | 9 | 0.64 | 955 | 6.4 | 0.7 | 70 | 25 |
| EX 22 | 0.045 | 25 | 50 | 3.0 | 0.12 | 8 | 0.32 | 950 | 6.4 | 0.8 | 70 | 22 |
| CE 1 | 0.045 | 25 | 50 | 0.0 | 0.00 | 8 | 0.32 | 950 | 0.0 | 0.0 | 0 | 25 |
| CE 2 | 0.045 | 25 | 50 | 3.0 | 0.12 | - | - | - | - | - | - | 25 |
| CE 3 | 0.045 | 25 | 50 | 7.0 | 0.28 | 8 | 0.32 | 950 | 6.4 | 0.8 | 70 | 25 |
| CE 4 | 0.045 | 9 | 50 | 3.0 | 0.33 | 8 | 0.89 | 950 | 6.4 | 0.8 | 70 | 25 |

(continued)

| | Aluminum plate | Anodized film | | | | | | | | | | Barrier layer |
|---|---|---|---|---|---|---|---|---|---|---|---|---|
| | | Large-diameter portion | | | | Small-diameter portion | | | | | | |
| | Al-Fe intermetallic compound content (wt%) | Average diameter B (nm) | Depth A (nm) | Average height k of protrusions (nm) | k/B | Average diameter C (nm) | C/B | Depth (nm) | Average height h of protrusions (nm) | h/C | Sealing ratio (%) | Thickness (nm) |
| CE 5 | 0.045 | 70 | 50 | 3.0 | 0.04 | 8 | 0.11 | 950 | 6.4 | 0.8 | 70 | 25 |
| CE 6 | 0.045 | 25 | 65 | 3.0 | 0.12 | 8 | 0.32 | 935 | 6.4 | 0.8 | 70 | 25 |
| CE 7 | 0.045 | 25 | 50 | 0.0 | 0.00 | 8 | 0.32 | 950 | 0,0 | 0.0 | 0 | 25 |
| CE 8 | 0.045 | 25 | 4 | 3.0 | 0.12 | 8 | 0.32 | 996 | 6.4 | 0.8 | 70 | 25 |
| CE 9 | 0.045 | 25 | 25 | 3.0 | 0.12 | 22 | 0.88 | 975 | 6.4 | 0.3 | 5 | 25 |

<Manufacture of Lithographic Printing Plate Precursor>

An undercoat-forming coating liquid of the composition indicated below was applied onto each lithographic printing plate support manufactured as described above to a coating weight after drying of 28 mg/$m^2$ to thereby form an undercoat.

<Undercoat-Forming Coating Liquid>

* Undercoating compound (1) of the structure shown below 0.18 g
* Hydroxyethylimino diacetic acid 0.10 g
* Methanol 55.24 g
* Water 6.15 g

[Chemical Formula 1]

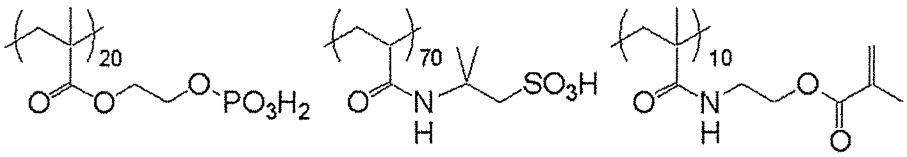

Undercoating compound (1)

Then, an image recording layer-forming coating liquid was applied onto the thus formed undercoat by bar coating and dried in an oven at 100°C for 60 seconds to form an image recording layer having a coating weight after drying of 1.3 g/$m^2$.

The image recording layer-forming coating liquid was obtained by mixing with stirring the photosensitive solution and the microgel solution shown below just before use in application.

<Photosensitive Solution>

* Binder polymer (1) [of the structure below] 0.24 g
* Infrared absorber (1) [of the structure below] 0.030 g
* Radical polymerization initiator (1) [of the structure below] 0.162 g
* Polymerizable compound, tris(acryloyloxyethyl)isocyanurate (NK Ester A-9300 available from Shin-Nakamura Chemical Corporation) 0.192 g
* Low-molecular-weight hydrophilic compound, tris(2-hydroxyethyl)isocyanurate 0.062 g
* Low-molecular-weight hydrophilic compound (1) [of the structure below] 0.052 g
* Ink receptivity enhancer
Phosphonium compound (1) [of the structure below] 0.055 g
* Ink receptivity enhancer
Benzyl-dimethyl-octyl ammonium·$PF_6$ salt 0.018 g
* Betaine compound (C-1) [of the structure below] 0.010 g
* Fluorosurfactant (1) (weight-average molecular weight, 10,000) [of the structure below] 0.008 g
* Methyl ethyl ketone 1.091 g
* 1-Methoxy-2-propanol 8.609 g

[Microgel Solution]

* Microgel (1) 2.640 g
* Distilled water 2.425 g

The binder polymer (1), the infrared absorber (1), the radical polymerization initiator (1), the phosphonium compound (1), the low-molecular-weight hydrophilic compound (1) and the fluorosurfactant (1) have the structures represented by the following formulas:

[Chemical Formula 2]

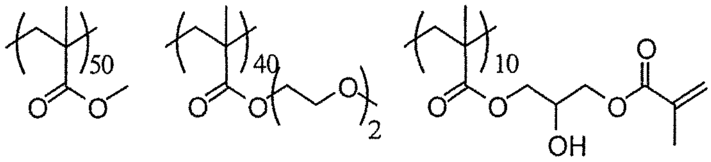

(Mw70,000)

Binder polymer (1)

[Chemical Formula 3]

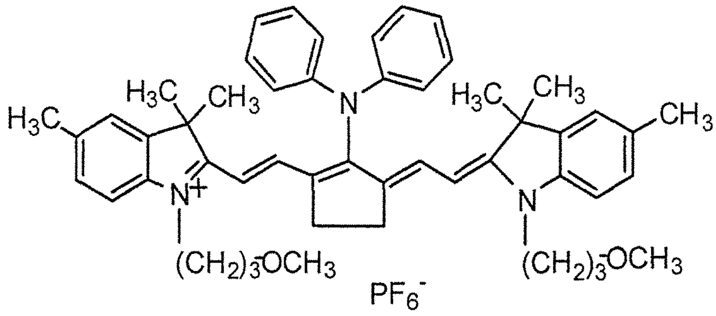

Infrared absorber (1)

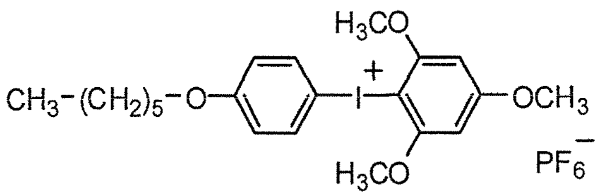

Polymerization initiator (1)

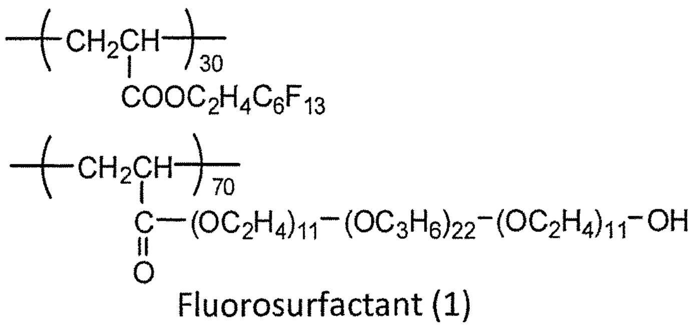

Fluorosurfactant (1)

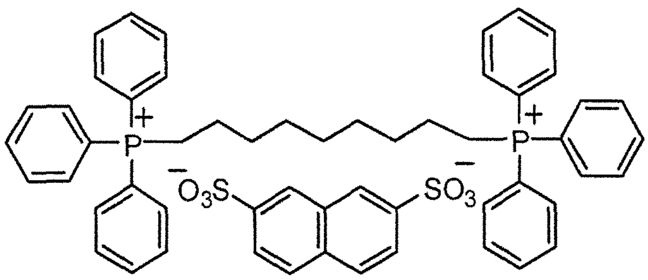

Phosphonium compound (1)

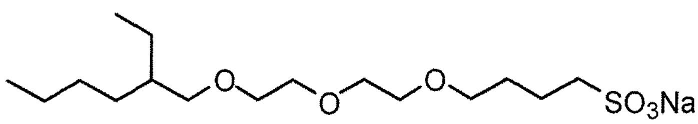

Low-molecular-weight hydrophilic compound (1)

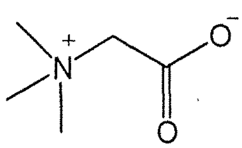

(C-1)

The microgel (1) was synthesized as follows.

<Synthesis of Microgel (1)>

For the oil phase component, 10g of an adduct of trimethylolpropane with xylene diisocyanate (Takenate D-110N available from Mitsui Takeda Chemicals, Inc.), 3.15 g of pentaerythritol triacrylate (SR444 available from Nippon Kayaku Co., Ltd.) and 0.1 g of Pionin A-41C (available from Takemoto Oil & Fat Co., Ltd.) were dissolved in 17 g of ethyl acetate. For the aqueous phase component, 40 g of a 4 wt% aqueous solution of PVA-205 was prepared. The oil phase component and the aqueous phase component were mixed and emulsified in a homogenizer at 12,000 rpm for 10 minutes. The resulting emulsion was added to 25 g of distilled water and the mixture was stirred at room temperature for 30 minutes, then at 50°C for 3 hours. The thus obtained microgel solution was diluted with distilled water so as to have a solids concentration of 15 wt% and used as the microgel (1). The average particle size of the microgel as measured by a light scattering method was 0.2 μm.

Then, a protective layer-forming coating liquid of the composition indicated below was applied onto the thus formed image recording layer by bar coating and dried in an oven at 120°C for 60 seconds to form a protective layer having a coating weight after drying of 0.15 $g/m^2$, thereby obtaining a lithographic printing plate precursor.

<Protective Layer-Forming Coating Liquid>

* Dispersion of an inorganic layered compound (1) 1.5 g
* 6 wt% Aqueous solution of polyvinyl alcohol (CKS50; modified with sulfonic acid; degree of saponification, at least 99 mol%; degree of polymerization, 300; available from The Nippon Synthetic Chemical Industry Co., Ltd.) 0.55 g
* 6 wt% Aqueous solution of polyvinyl alcohol (PVA-405; degree of saponification: 81.5 mol%; degree of polymerization: 500; available from Kuraray Co., Ltd.) 0.03 g
* 1 wt% Aqueous solution of surfactant (EMALEX 710 available from Nihon Emulsion Co., Ltd.) 8.60 g
* Ion exchanged water 6.0 g

The dispersion of an inorganic layered compound (1) was prepared as follows.

(Preparation of Dispersion of Inorganic Layered Compound (1))

To 193.6 g of ion-exchanged water was added 6.4 g of synthetic mica Somasif ME-100 (available from Co-Op Chemical Co., Ltd.) and the mixture was dispersed in a homogenizer to an average particle size (as measured by a laser scattering method) of 3 μm. The resulting dispersed particles had an aspect ratio of at least 100.

<Evaluation of Lithographic Printing Plate Precursor>

(On-Press Developability)

The resulting lithographic printing plate precursor was exposed by Luxel PLATESETTER T-6000III from FUJIFILM Corporation equipped with an infrared semiconductor laser at an external drum rotational speed of 1,000 rpm, a laser power of 70% and a resolution of 2,400 dpi. The exposed image was set to contain a solid image and a 50% halftone chart of a 20μm-dot FM screen.

The resulting lithographic printing plate precursor after exposure was mounted without development process on the plate cylinder of a Lithrone 26 printing press available from Komori Corporation. A fountain solution of Ecolity-2 (FUJIFILM Corporation) / tap water at (a volume ratio of) 2/98 and Values-G (N) black ink (Dainippon Ink & Chemicals, Inc.) were used. The fountain solution and the ink were supplied by the standard automatic printing start-up procedure on the Lithrone 26 to perform on-press development, and printing was performed with 100 sheets of Tokubishi art paper (76.5 kg) at a printing rate of 10,000 sheets per hour.

The on-press developability was evaluated as the number of sheets of printing paper required to reach the state in which no ink is transferred to halftone non-image areas after the completion of the on-press development of the unexposed areas of the 50% halftone chart on the printing press. The on-press developability was rated as, in the order from the excellent one, "A" (when the number of sheets was up to 20), "B" (when the number of sheets was from 21 to 40), and "C" (when the number of sheets was 41 or more). The results are shown in Table 3. The on-press developability is preferably not rated "C" for practical use.

(Resistance to Dotted Scumming)

The resulting lithographic printing plate precursor was conditioned in humidity with an interleaving sheet at 25°C and 70% RH for 1 hour, wrapped with aluminum kraft paper and heated in an oven set at 60°C for 15 days.
Then, the temperature was decreased to room temperature. On-press development was performed on the same type of printing press by the same procedure as above and 500 impressions were made. The 500th impression was visually checked and the number per 80 $cm^2$ of print stains with a size of at least 20 $\mu$m was counted.
The resistance to dotted scumming was rated "E" when the number of stains was at least 250, "D" when the number of stains was at least 150 but less than 250, "C" when the number of stains was at least 100 but less than 150, "B" when the number of stains was at least 50 but less than 100, and "A" when the number of stains was less than 50. The results are shown in Table 3. The resistance to dotted scumming is preferably not rated "E" for practical use.

(Press Life)

On-press development was performed on the same type of printing press by the same procedure as above and printing was further continued. The press life was evaluated by the number of impressions at the time when the decrease in density of a solid image became visually recognizable. The press life was rated "C" when the number of impressions was less than 20,000, "B" when the number of impressions was at least 20,000 but less than 30,000, and "A" when the number of impressions was 30,000 or more. The results are shown in Table 3. The press life is preferably not rated "C" for practical use.

(Scratch Resistance)

The surface of the resulting lithographic printing plate support was subjected to a scratch test to evaluate the scratch resistance of the lithographic printing plate support.
The scratch test was performed using a continuous loading scratching intensity tester (SB-53 manufactured by Shinto Scientific Co., Ltd.) while moving a sapphire needle with a diameter of 0.4 mm at a moving velocity of 10 cm/s at a load of 100 g.
As a result, the support in which scratches due to the needle did not reach the surface of the aluminum alloy plate (base) was rated "A" as having excellent scratch resistance and the support in which scratches reached the plate surface was rated "B." The results are shown in Table 3. The scratch resistance is preferably not rated "B" for practical use.
The lithographic printing plate support exhibiting excellent scratch resistance at a load of 100 g can suppress the transfer of scratches to the image recording layer when the lithographic printing plate precursor prepared therefrom is wound up or superposed on another, thus reducing scumming in non-image areas.
[Table 3]

Table 3

| | Evaluation items | | | |
|---|---|---|---|---|
| | Resistance to dotted scumming | On-press developability | Press life | Scratch resistance |
| | 5-grade evaluation (A~E) | 3-grade evaluation (A~C) | 3-grade evaluation (A~C) | 2-grade evaluation (A~B) |
| EX 1 | D | A | B | A |
| EX 2 | C | A | B | A |
| EX 3 | B | A | B | A |
| EX 4 | A | A | B | A |
| EX 5 | C | B | A | A |

(continued)

| | Evaluation items | | | |
|---|---|---|---|---|
| | Resistance to dotted scumming | On-press developability | Press life | Scratch resistance |
| | 5-grade evaluation (A~E) | 3-grade evaluation (A~C) | 3-grade evaluation (A~C) | 2-grade evaluation (A~B) |
| EX 6 | B | A | A | A |
| EX 7 | D | A | B | A |
| EX 8 | C | A | B | A |
| EX 9 | D | A | B | A |
| EX 10 | B | A | B | A |
| EX 11 | A | A | B | A |
| EX 12 | D | A | B | A |
| EX 13 | A | A | B | A |
| EX 14 | C | A | B | A |
| EX 15 | A | A | B | A |
| EX 16 | B | A | B | A |
| EX 17 | B | A | B | A |
| EX 18 | B | A | B | A |
| EX 19 | B | B | B | A |
| EX 20 | B | A | B | A |
| EX 21 | B | A | B | A |
| EX 22 | B | A | B | A |
| CE 1 | E | A | B | A |
| CE 2 | B | A | B | B |
| CE 3 | B | C | B | A |

(continued)

| | Evaluation items | | | |
|---|---|---|---|---|
| | Resistance to dotted scumming | On-press developability | Press life | Scratch resistance |
| | 5-grade evaluation (A~E) | 3-grade evaluation (A~C) | 3-grade evaluation (A~C) | 2-grade evaluation (A~B) |
| CE 4 | B | A | C | A |
| CE 5 | C | C | A | A |
| CE 6 | B | C | A | A |
| CE 7 | E | A | B | A |
| CE 8 | B | A | C | A |
| CE 9 | D | C | B | A |

As can be seen from Table 3, every lithographic printing plate precursor obtained by using the lithographic printing plate support of the invention exhibited excellent resistance to dotted scumming and excellent on-press developability. Every lithographic printing plate obtained by using the lithographic printing plate support of the invention exhibited a long press life. The lithographic printing plate supports of the invention all exhibited excellent scratch resistance.

In particular, as is clear from the comparison between Examples 1 to 4, more excellent resistance to dotted scumming was exhibited at a higher sealing ratio. The resistance to dotted scumming was even more excellent at a ratio (h/C) of 0.5 or more (in other words, at a sealing ratio of 30% or more).

From the comparison between Examples 3, 5 and 16, it was revealed that the on-press developability and resistance to dotted scumming were more excellent in Example 3 (average diameter B = 25 nm) and Example 16 (average diameter B = 12 nm) in which the average diameter B of the large-diameter portions was in a range of 10 to 50 nm than in Example 5 (average diameter B = 60 nm) in which the average diameter B of the large-diameter portions was in excess of 50 nm.

From the comparison between Examples 3 and 7 and the comparison between Examples 4 and 8, it was revealed that the resistance to dotted scumming was more excellent in Examples 3 and 4 (average diameter C = 8 nm) in which the average diameter C of the small-diameter portions was not greater than 15 nm than in Examples 7 and 8 (average diameter C = 16 nm) in which the average diameter C of the small-diameter portions was in excess of 15 nm.

From the comparison between Examples 3, 6, 17 and 19, it was revealed that the on-press developability was more excellent in Example 3 (depth A = 50 nm), Example 6 (depth A = 55 nm) and Example 17 (depth A = 12 nm) in which the depth A of the large-diameter portions was in a range of 10 to 55 nm than in Example 19 (depth A = 60 nm) in which the depth A of the large-diameter portions was in excess of 55 nm.

From the comparison between Examples 3 and 13, it was revealed that the resistance to dotted scumming was more excellent in Example 13 (barrier layer thickness = 35 nm) in which the thickness of the barrier layer was not less than 30 nm than in Example 3 (barrier layer thickness = 25 nm) in which the thickness of the barrier layer was less than 30 nm.

From the comparison between Examples 3, 14 and 15, it was revealed that the resistance to dotted scumming was more excellent with a lower content of intermetallic compounds. In particular, when the intermetallic compound content was up to 0.060 wt%, even more excellent resistance to dotted scumming was exhibited.

On the other hand, it was revealed that the resistance to dotted scumming was insufficient in Comparative Examples 1 and 7 in which the inside of the small-diameter portions was not sealed with the boehmite protrusions; the scratch resistance was insufficient in Comparative Example 2 in which there is no small-diameter portion; the on-press developability was insufficient in Comparative Example 3 in which the ratio k/B was in excess of 0.27; the press life was insufficient in Comparative Example 4 in which the average diameter of the large-diameter portions was less than 10 nm; the on-press developability was insufficient in Comparative Example 5 in which the average diameter of the large-diameter portions was in excess of 60 nm; the on-press developability was insufficient in Comparative Example 6 in which the depth of the large-diameter portions was in excess of 60 nm; the press life was insufficient in Comparative Example 8 in which the depth of the large-diameter portions was less than 5 nm; and the on-press developability was insufficient in Comparative Example 9 in which the ratio C/B was in excess of 0.85.

REFERENCE SIGNS LIST

| | |
|---|---|
| 1, 12 | aluminum plate |
| 2, 4 | roller brush |
| 3 | abrasive slurry |
| 5, 6, 7, 8 | support roller |
| ta | anodic reaction time |
| tc | cathodic reaction time |
| tp | a period of time in which current reaches a peak from zero |
| Ia | peak current on the anode cycle side |
| Ic | peak current on the cathode cycle side |
| 10 | lithographic printing plate support |
| 14, 14a, 14b, 14c, 14d, 14e | anodized aluminum film |
| 16, 16a, 16b, 16c, 16d, 16e | micropore |
| 18, 18b, 18c | large-diameter portion |
| 20, 20a, 20c | small-diameter portion |
| 50 | main electrolytic cell |
| 51 | alternating current source |
| 52 | radial drum roller |
| 53a, 53b | main electrode |
| 54 | electrolytic solution feed inlet |
| 55 | electrolytic solution |
| 56 | auxiliary anode |
| 60 | auxiliary anode cell |
| 100 | boehmite protrusion |
| W | aluminum plate |
| 610 | anodizing apparatus |
| 612 | power supply cell |
| 614 | electrolytic cell |
| 616 | aluminum plate |
| 618, 626 | electrolytic solution |
| 620 | power supply electrode |
| 622, 628 | roller |
| 624 | nip roller |
| 630 | electrolytic electrode |
| 632 | cell wall |
| 634 | direct current source |

## Claims

1. A lithographic printing plate support, comprising an aluminum plate and an anodized film of aluminum formed on the aluminum plate and having micropores extending in the anodized film from a surface of the anodized film opposite from the aluminum plate in a depth direction,
wherein each of the micropores has a large-diameter portion which extends from the surface of the anodized film to a depth (depth A) of 5 to 60 nm and a small-diameter portion which communicates with a bottom of the large-diameter portion and extends to a depth of 890 to 2,000 nm from a level of communication between the small-diameter portion and the large-diameter portion,
wherein the large-diameter portion has an average diameter B of 10 to 60 nm at the surface of the anodized film,
wherein a ratio (C/B) of an average diameter C of the small-diameter portion at the level of communication to the average diameter B of the large-diameter portion at the surface of the anodized film is up to 0.85,

wherein at least a part of an inside of the small-diameter portion is sealed with protrusions made of boehmite, and wherein a ratio (k/B) of an average height k of protrusions made of boehmite inside the large-diameter portion to the average diameter B of the large-diameter portion is up to 0.27.

**2.** The lithographic printing plate support according to claim 1, wherein a ratio (h/C) of an average height h of the protrusions inside the small-diameter portion to the average diameter C of the small-diameter portion is from 0.5 to 1.0.

**3.** The lithographic printing plate support according to claim 1 or 2, wherein a sealing ratio of the small-diameter portion is at least 30%.

**4.** The lithographic printing plate support according to any one of claims 1 to 3, wherein the average diameter C of the small-diameter portion is up to 15 nm.

**5.** The lithographic printing plate support according to any one of claims 1 to 4, wherein a thickness of the anodized film from a bottom of the small-diameter portion to a surface of the aluminum plate is at least 30 nm.

**6.** The lithographic printing plate support according to any one of claims 1 to 5, wherein a content of intermetallic compounds in the alumunum plate is up to 0.060 wt%.

**7.** The lithographic printing plate support according to any one of claims 1 to 6, wherein the average diameter B of the large-diameter portion is from 10 to 50 nm.

**8.** The lithographic printing plate support according to any one of claims 1 to 7, wherein the depth A of the large-diameter portion is from 10 to 55 nm.

**9.** A lithographic printing plate support manufacturing method of manufacturing the lithographic printing plate support according to any one of claims 1 to 8, comprising:

a first anodizing treatment step for anodizing the aluminum plate;
a pore-widening treatment step for enlarging a diameter of the micropores in the anodized film by bringing the aluminum plate having the anodized film obtained in the first anodizing treatment step into contact with an aqueous acid or alkali solution;
a second anodizing treatment step for anodizing the aluminum plate obtained in the pore-widening treatment step; and
a water vapor treatment step for bringing the aluminum plate obtained in the second anodizing treatment step into contact with water vapor at a temperature of 150°C or higher but lower than 300°C.

**10.** A lithographic printing plate support manufacturing method of manufacturing the lithographic printing plate support according to any one of claims 1 to 8, comprising:

a first anodizing treatment step for anodizing the aluminum plate;
a second anodizing treatment step for anodizing the aluminum plate obtained in the first anodizing treatment step; and
a water vapor treatment step for bringing the aluminum plate obtained in the second anodizing treatment step into contact with water vapor at 150°C or more but less than 300°C.

**11.** A lithographic printing plate precursor comprising: the lithographic printing plate support according to any one of claims 1 to 8; and an image recording layer formed on the lithographic printing plate support.

# FIG.1

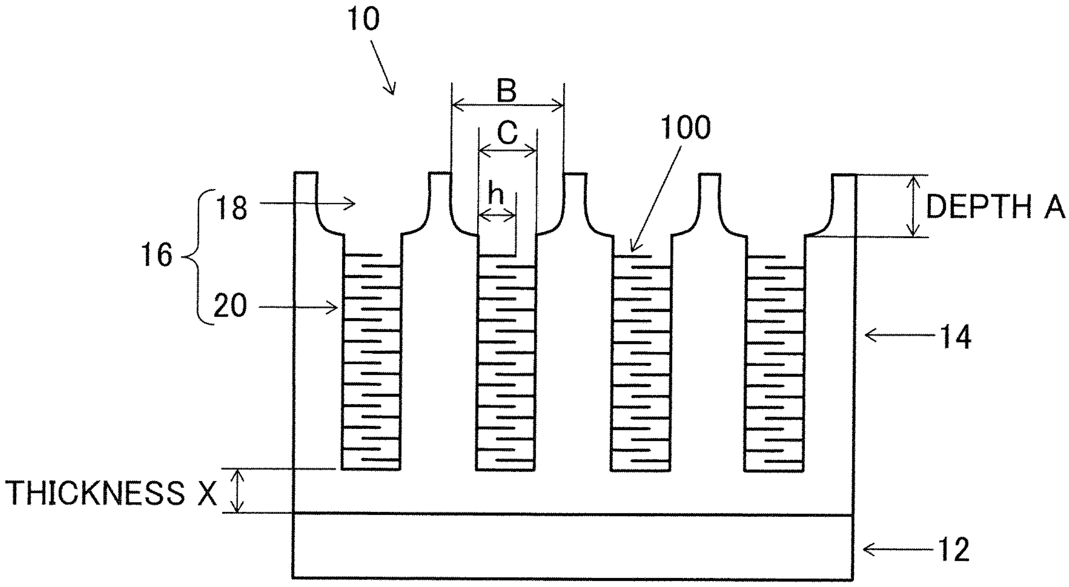
10
B
C
100
h
18
16
DEPTH A
20
14
THICKNESS X
12

# FIG.2

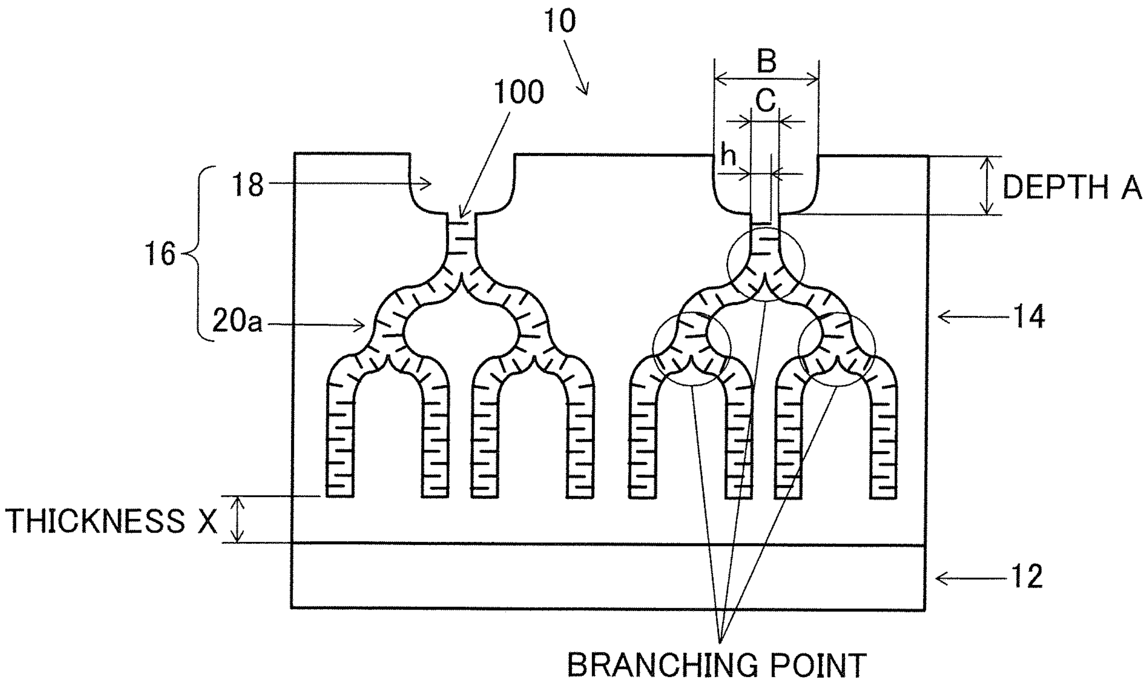
10
B
100
C
h
18
DEPTH A
16
20a
14
THICKNESS X
12
BRANCHING POINT

FIG.3

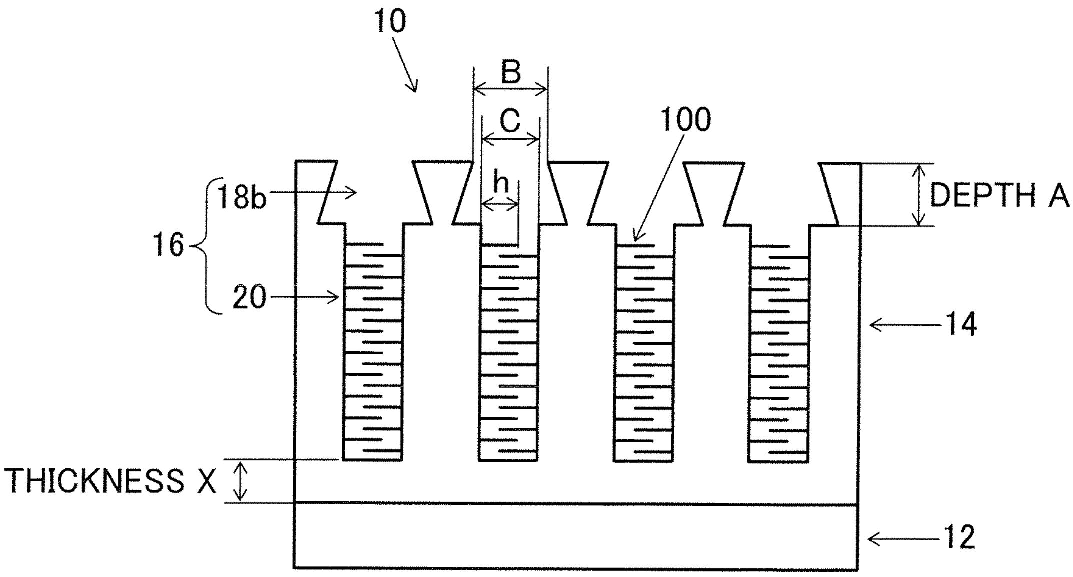
10
B
C
100
h
18b
DEPTH A
16
20
14
THICKNESS X
12

FIG.4

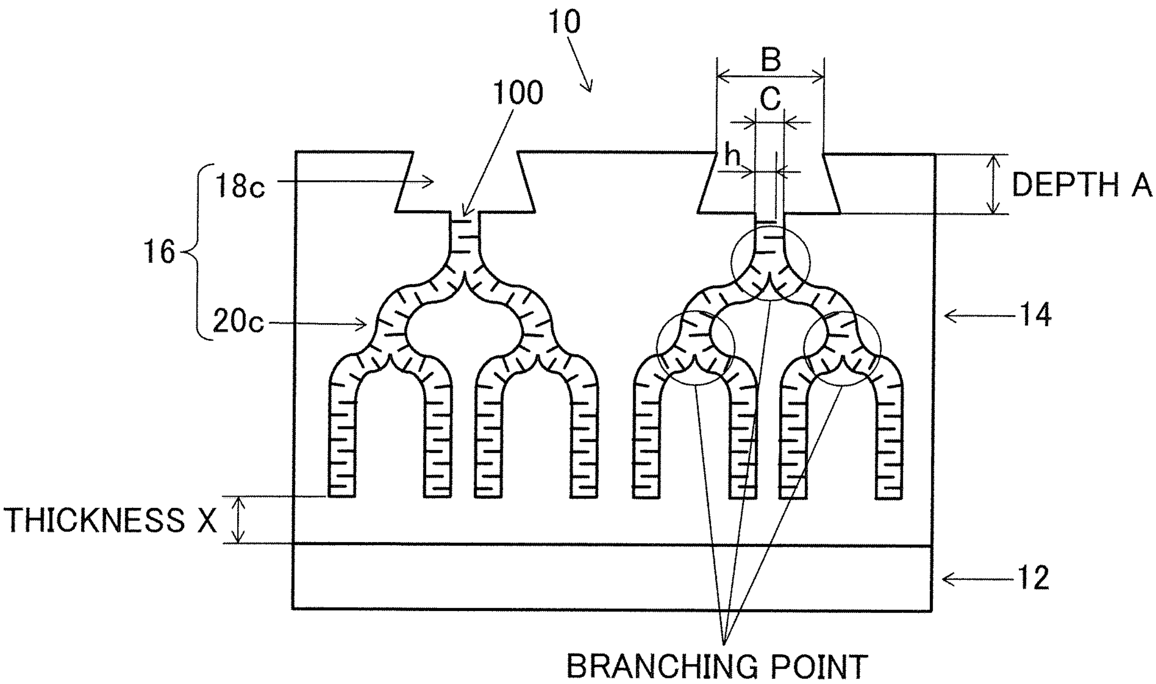
10
B
100
C
h
18c
DEPTH A
16
20c
14
THICKNESS X
12
BRANCHING POINT

FIG.5

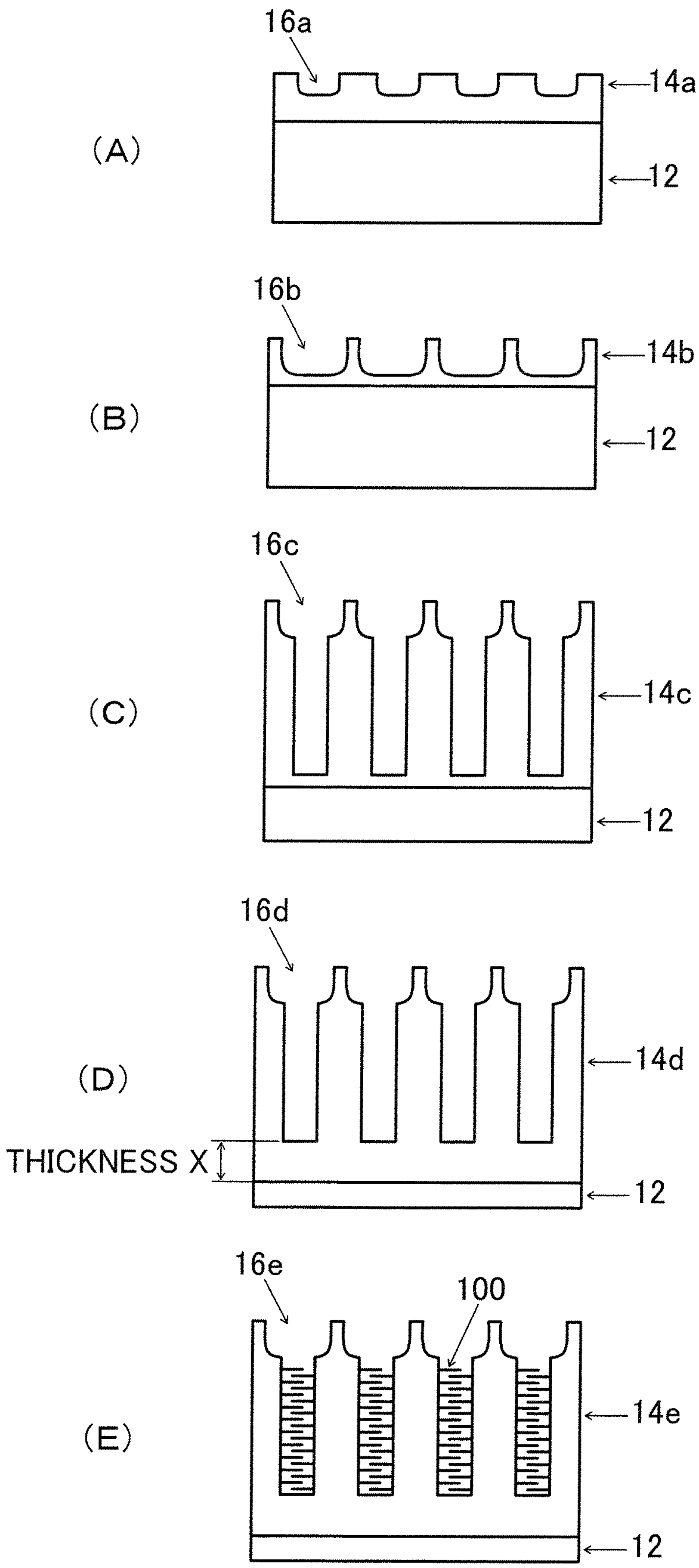
16a
14a
(A)
12
16b
14b
(B)
12
16c
14c
(C)
12
16d
14d
(D)
THICKNESS X
12
16e
100
14e
(E)
12

FIG.6

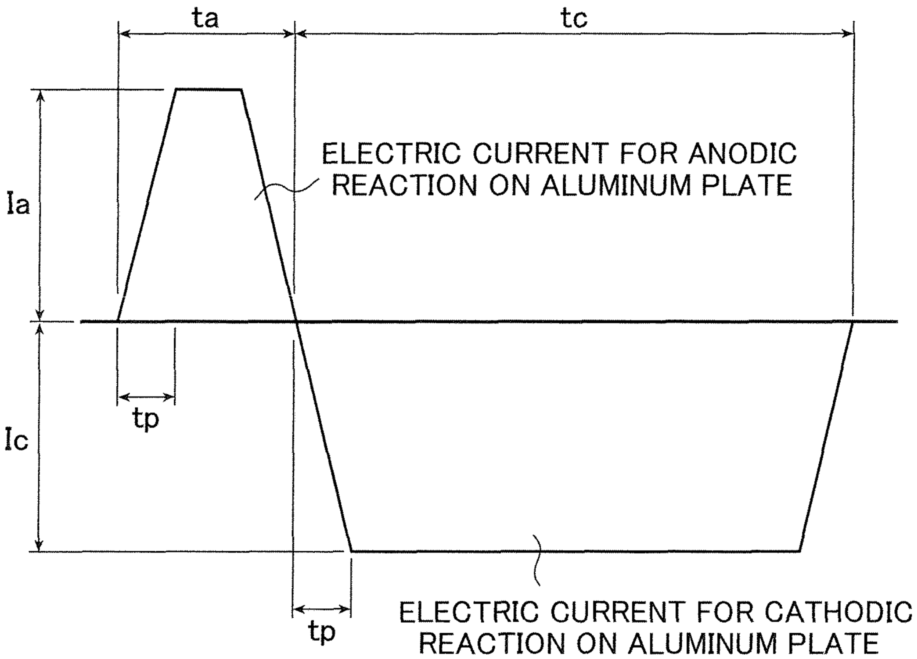
ta
tc
Ia
Ic
tp
tp
ELECTRIC CURRENT FOR ANODIC REACTION ON ALUMINUM PLATE
ELECTRIC CURRENT FOR CATHODIC REACTION ON ALUMINUM PLATE

FIG.7

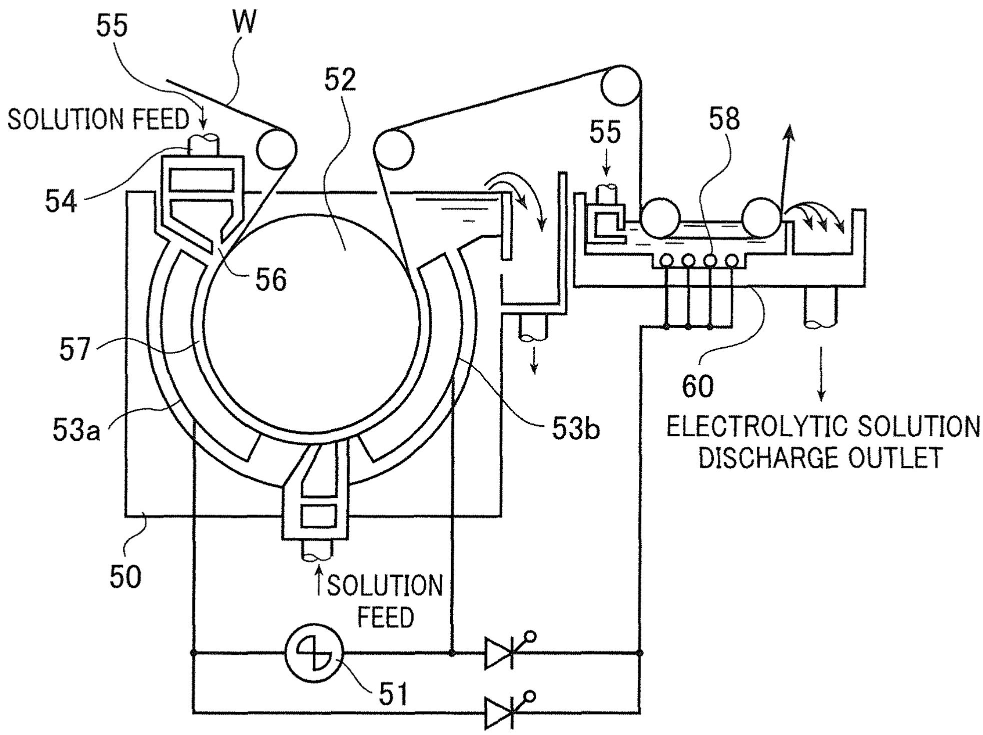
55
W
52
SOLUTION FEED
55
58
54
56
57
53a
53b
60
ELECTROLYTIC SOLUTION DISCHARGE OUTLET
50
SOLUTION FEED
51

FIG.8

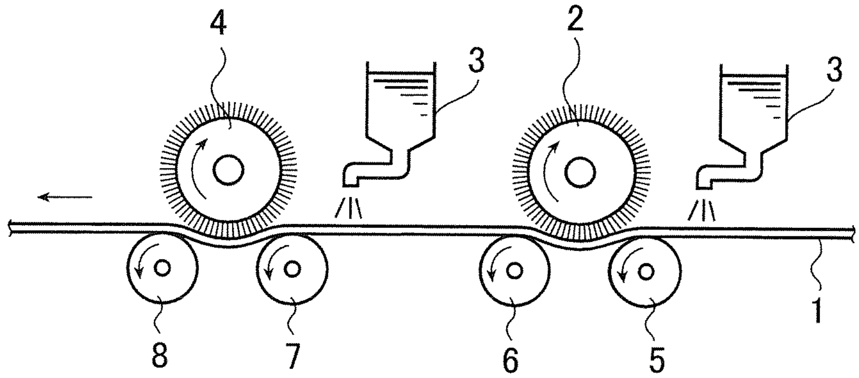


FIG.9

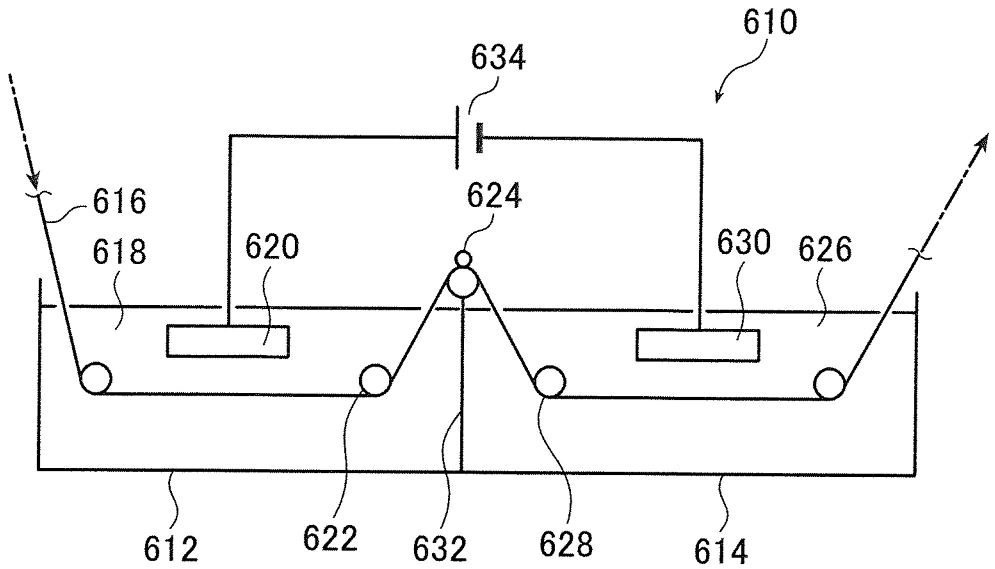

## INTERNATIONAL SEARCH REPORT

International application No. PCT/JP2013/050673

A. CLASSIFICATION OF SUBJECT MATTER
*B41N3/03*(2006.01)i

According to International Patent Classification (IPC) or to both national classification and IPC

B. FIELDS SEARCHED

Minimum documentation searched (classification system followed by classification symbols)
B41N3/03

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2011/081064 A1 (Fujifilm Corp.), 07 July 2011 (07.07.2011), & EP 2520439 A1 & CN 102686409 A | 1-11 |
| A | JP 2007-237397 A (Fujifilm Corp.), 20 September 2007 (20.09.2007), (Family: none) | 1-11 |
| A | JP 11-291657 A (Fuji Photo Film Co., Ltd.), 26 October 1999 (26.10.1999), (Family: none) | 1-11 |
| A | JP 2002-365791 A (Fuji Photo Film Co., Ltd.), 18 December 2002 (18.12.2002), & US 2002/182538 A1 & EP 1219464 A2 | 1-11 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 February, 2013 (26.02.13) | 05 March, 2013 (05.03.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2013/050673

C (Continuation). DOCUMENTS CONSIDERED TO BE RELEVANT

| Category* | Citation of document, with indication, where appropriate, of the relevant passages | Relevant to claim No. |
|---|---|---|
| A | JP 11-174663 A (Konica Corp.), 02 July 1999 (02.07.1999), (Family: none) | 1-11 |
| A | JP 10-264548 A (Mitsubishi Paper Mills Ltd.), 06 October 1998 (06.10.1998), (Family: none) | 1-11 |
| A | JP 2-57391 A (Eastman Kodak Co.), 27 February 1990 (27.02.1990), & US 4865951 A1 & EP 316240 A1 | 1-11 |
| A | JP 60-72794 A (Fuji Photo Film Co., Ltd.), 24 April 1985 (24.04.1985), (Family: none) | 1-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2011081064 A
- JP 48018327 B
- JP 50040047 B
- GB 1412768 B
- JP 2005254638 A
- US 2714066 A
- US 3181461 A
- JP 2003001956 A
- JP 2009255434 A
- JP 48041708 B
- US 3458311 A
- JP 55049729 B


### Non-patent literature cited in the description


- Senryo Binran. The Society of Synthetic Organic Chemistry, 1970